# EUROPEAN PATENT APPLICATION

(11) **EP 4 793 949 A1**
(43) Date of publication of application: **19.08.2026**
(21) Application number: 26158072.4
(22) Date of filing: 12.02.2026
(51) Int. Cl.: G11C 7/10, G11C 16/08, G11C 16/26

(54) **NONVOLATILE MEMORY DEVICE WITH MEMORY CELL ARRAYS**

(30) Priority: 13.02.2025 KR 20250018924; 17.02.2025 KR 20250020410; 10.07.2025 KR 20250093103
(71) Applicant: Samsung Electronics Co., Ltd., Suwon-si, Gyeonggi-do 16677 (KR)
(72) Inventor: SONG, Seunghwan, 16677 Suwon-si (KR); SONG, Seongjin, 16677 Suwon-si (KR); JEONG, Youngseok, 16677 Suwon-si (KR); SONG, Kiwhan, 16677 Suwon-si (KR); KIM, Wandong, 16677 Suwon-si (KR); CHOE, Jeongin, 16677 Suwon-si (KR); CHOI, Yonghyuk, 16677 Suwon-si (KR)
(74) Representative: Marks & Clerk LLP

(57) **Abstract**

A nonvolatile memory device includes a memory cell array including a plurality of planes, a page buffer circuit connected to the memory cell array through a plurality of bit lines, an input/output circuit connected to the page buffer circuit through a plurality of data lines, a control logic circuit controlling an operation for the planes in response to a command, a first command-address pad set electrically connected to the control logic circuit and receiving a first command, and a second command-address pad set electrically connected to the control logic circuit and receiving a second command. A time during which the first command is received overlaps with a time during which the second command is received.

## Description

### BACKGROUND

Semiconductor memory devices are broadly classified into volatile memory devices and non-volatile memory devices. Volatile memory devices have the advantage of fast reading and writing speeds, but have the disadvantage of losing stored content when power supply is cut off. On the other hand, non-volatile memory devices retain their content even when the power supply is interrupted. Therefore, non-volatile memory devices are used to store content to be retained regardless of whether power is supplied.

A representative example of a non-volatile memory device is a flash memory device. Flash memory devices are widely used as storage media for voice and video data in information devices such as computers, mobile phones, smartphones, digital cameras, camcorders, voice recorders, MP3 players, personal digital assistants (PDAs), handheld PCs, game consoles, faxes, scanners, and printers. As the number of information devices using non-volatile memory devices as storage devices has increased, improvements in data input/output performance have been presented.

### SUMMARY

Implementations of the present disclosure described herein relate to a nonvolatile memory device. In particular, implementations of the present disclosure provide a nonvolatile memory device capable of improving data input/output performance.

Implementations of the present disclosure provide a nonvolatile memory device including a memory cell array including a plurality of planes, a page buffer circuit connected to the memory cell array through a plurality of bit lines, an input/output circuit connected to the page buffer circuit through a plurality of data lines, a control logic circuit controlling an operation for the planes in response to a command, a first command-address pad set electrically connected to the control logic circuit and receiving a first command, and a second command-address pad set electrically connected to the control logic circuit and receiving a second command. A time during which the first command is received overlaps with a time during which the second command is received. The control logic circuity controlling operation of the for the planes in response to a command.

The first command may comprise at least one of a first read command requesting a read operation for a first plane among the planes, a first SR command requesting to check whether the read operation corresponding to the first plane is completed, and a first data out command requesting an output of data read from the first plane. The second command may comprise at least one of a second read command requesting a read operation for a second plane among the planes, a second SR command requesting to check whether the read operation corresponding to the second plane is completed, and a second data out command requesting an output of data read from the second plane.

The nonvolatile memory device may further comprise a command-address control circuit electrically connected to the first command-address pad set and the second command-address pad set, and the command-address control circuit selects at least one plane to which the first command-address pad set and the second command-address pad set are allocated among the planes.

The command-address control circuit may determine the plane to which the first command-address pad set and the second command-address pad set are allocated among the planes based on a size of data.

When the size of the data is larger than a reference size, at least two planes among the planes may be allocated to the first command-address pad set.

A command-address line connected to the second command-address pad set may be floated.

When the size of the data is smaller than a reference size, the first command-address pad set and the second command-address pad set may be allocated to different planes from each other among the planes.

The nonvolatile memory device may further comprise a third command-address pad set electrically connected to the control logic circuit and receiving a third command and a fourth command-address pad set electrically connected to the control logic circuit and receiving a fourth command, and a command-address line connected to the third command-address pad set and a command-address line connected to the fourth command-address pad set are floated.

The nonvolatile memory device may further comprise a third command-address pad set electrically connected to the control logic circuit and receiving a third command and a fourth command-address pad set electrically connected to the control logic circuit and receiving a fourth command. The first command-address pad set, the second command-address pad set, the third command-address pad set, and the fourth command-address pad set are allocated to different planes from each other among the planes.

The command-address control circuit may determine the plane to which the first command-address pad set and the second command-address pad set are allocated among the planes in response to a command-address change request received from a memory controller.

The command-address change request may comprise a header and a body, and the body includes address information for a plane to which the first command-address pad set is allocated.

The command-address change request may comprise a logical unit number (LUN) selection signal, and the LUN selection signal comprises address information for a way to which the first command-address pad set is allocated.

The command-address control circuit and the memory cell array may be arranged on the same die.

The command-address control circuit and the memory cell array may be arranged on different dies.

The nonvolatile memory device may further comprise a first data pad set electrically connected to the input/output circuit and outputting a first data corresponding to the first command and a second data pad set electrically connected to the input/output circuit and outputting a second data corresponding to the second command.

Implementations of the present disclosure provide a nonvolatile memory device including a first chip and a second chip stacked on the first chip. The first chip includes a first memory cell array including a plurality of planes, a first page buffer circuit connected to the first memory cell array through a plurality of bit lines, a first input/output circuit connected to the first page buffer circuit through a plurality of data lines, a first control logic circuit controlling an operation for the planes in response to a first command, a first command-address pad set electrically connected to the first control logic circuit and electrically connected to a first command-address line, and a second command-address pad set electrically connected to the first control logic circuit and electrically connected to a second command-address line. The second chip includes a second memory cell array including a plurality of planes, a second page buffer circuit connected to the second memory cell array through a plurality of bit lines, a second input/output circuit connected to the second page buffer circuit through a plurality of data lines, a second control logic circuit controlling an operation for the planes in response to a second command, a third command-address pad set electrically connected to the first command-address line, and a fourth command-address pad set electrically connected to the second command-address line. A time during which a first command is received through the first command-address line overlaps with a time during which a second command is received through the second command-address line.

The first die further includes a first command-address control circuit electrically connected to the first command-address line and a second command-address control circuit electrically connected to the second command-address line, and the second die further includes a third command-address control circuit electrically connected to the first command-address line and a fourth command-address control circuit electrically connected to the second command-address line.

The first die and the second die are electrically connected to each other by a pad wiring method.

The first die and the second die are electrically connected to each other by a pad wiring method.

Implementations of the present disclosure provide a nonvolatile memory device including a memory cell array including a plurality of planes, a page buffer circuit connected to the memory cell array through a plurality of bit lines, an input/output circuit connected to the page buffer circuit through a plurality of data lines, a control logic circuit controlling an operation for the planes in response to a command, a first command-address pad set electrically connected to the control logic circuit and receiving a first command, a second command-address pad set electrically connected to the control logic circuit and receiving a second command, and at least one data pad set electrically connected to the input/output circuit and outputting a first data corresponding to the first command and a second data corresponding to the second command. The control logic circuit determines a plane to which the first and second command-address pad sets are allocated among the planes based on a data size in a data output operation.

Implementations of the present disclosure provide a nonvolatile memory device including a memory cell array including a plurality of planes, a page buffer circuit connected to the memory cell array through a plurality of bit lines, an input/output circuit connected to the page buffer circuit through a plurality of data lines, a control logic circuit controlling an operation for the planes in response to a command, a first command-address pad set electrically connected to the control logic circuit and allocated to a first plane among the planes, a second command-address pad set electrically connected to the control logic circuit and allocated to a second plane among the planes, a first data pad set electrically connected to the input/output circuit and allocated to the first plane, and a second data pad set electrically connected to the input/output circuit and allocated to the second plane.

The first command-address pad set is further allocated to a third plane among the planes, the second command-address pad set is further allocated to a fourth plane among the planes, the first data pad set is further allocated to the third plane among the planes, and the second data pad set is further allocated to the fourth plane among the planes.

The nonvolatile memory device further includes a third command-address pad set electrically connected to the control logic circuit and allocated to a third plane among the planes, a fourth command-address pad set electrically connected to the control logic circuit and allocated to a fourth plane among the planes, a third data pad set electrically connected to the input/output circuit and allocated to the third plane, and a fourth data pad set electrically connected to the input/output circuit and allocated to the fourth plane.

The first command-address pad set is further allocated to a third plane among the planes, the second command-address pad set is further allocated to a fourth plane among the planes, and the nonvolatile memory device includes a third data pad set allocated to the third plane and a fourth data pad set allocated to the fourth plane.

The first data pad set is further allocated to a fifth plane among the planes, the second data pad set is further allocated to a sixth plane among the planes, the third data pad set is further allocated to a seventh plane among the planes, the foruth data pad set is further allocated to an eighth plane among the planes, the first command-address pad set is further allocated to the fifth and seventh planes, and the second command-address pad set is further allocated to the sixth and eight planes.

The nonvolatile memory device further includes a third command-address pad set electrically connected to the control logic circuit and allocated to the first plane and a fourth command-address pad set electrically connected to the control logic circuit and allocated to the second plane.

The first command-address pad set receives a first command, the second command-address pad set receives a second command, and a time during which the first command is received overlaps with a time during which the second command is received.

Implementations of the present disclosure provide a nonvolatile memory device including a first chip and a second chip stacked on the first chip and electrically connected to the first chip via a wire. At least one of the first chip and the second chip includes a memory cell array including a plurality of planes, a page buffer circuit connected to the memory cell array through a plurality of bit lines, an input/output circuit connected to the page buffer circuit through a plurality of data lines, a control logic circuit controlling an operation for the planes in response to a command, a first command-address pad set electrically connected to the control logic circuit and allocated to a first plane among the planes, a second command-address pad set electrically connected to the control logic circuit and allocated to a second plane among the planes, a first data pad set electrically connected to the input/output circuit and allocated to the first plane, and a second data pad set electrically connected to the input/output circuit and allocated to the second plane.

The first command-address pad set is further allocated to a third plane among the planes, the second command-address pad set is further allocated to a fourth plane among the planes, the first data pad set is further allocated to the third plane, and the second data pad set is further allocated to the fourth plane.

The nonvolatile memory device further includes a third command-address pad set electrically connected to the control logic circuit and allocated to a third plane among the planes, a fourth command-address pad set electrically connected to the control logic circuit and allocated to a fourth plane among the planes, a third data pad set electrically connected to the input/output circuit and allocated to the third plane, and a fourth data pad set electrically connected to the input/output circuit and allocated to the fourth plane.

The first command-address pad set is further allocated to a third plane among the planes, the second command-address pad set is further allocated to a fourth plane among the planes, and the nonvolatile memory device includes a third data pad set electrically connected to the input/output circuit and allocated to the third plane and a fourth data pad set electrically connected to the input/output circuit and allocated to the fourth plane.

The first data pad set is further allocated to a fifth plane among the planes, the second data pad set is further allocated to a sixth plane among the planes, the third data pad set is further allocated to a seventh plane among the planes, the fourth data pad set is further allocated to an eighth plane among the planes, the first command-address pad set is further allocated to the fifth and seventh planes, and the second command-address pad set is further allocated to the sixth and eight planes.

The nonvolatile memory device further includes a third command-address pad set electrically connected to the control logic circuit and allocated to the first plane and a fourth command-address pad set electrically connected to the control logic circuit and allocated to the second plane.

The first command-address pad set receives a first command, the second command-address pad set receives a second command, and a time during which the first command is received overlaps with a time during which the second command is received.

Implementations of the present disclosure provide a nonvolatile memory device including a first chip and a second chip stacked on the first chip and electrically connected to the first chip by a through-silicon via (TSV). At least one of the first chip and the second chip includes a memory cell array including a plurality of planes, a page buffer circuit connected to the memory cell array through a plurality of bit lines, an input/output circuit connected to the page buffer circuit through a plurality of data lines, a control logic circuit controlling an operation for the planes in response to a command, a first command-address pad set electrically connected to the control logic circuit and allocated to a first plane among the planes, a second command-address pad set electrically connected to the control logic circuit and allocated to a second plane among the planes, a first data pad set electrically connected to the input/output circuit and allocated to the first plane, and a second data pad set electrically connected to the input/output circuit and allocated to the second plane.

The first command-address pad set is further allocated to a third plane among the planes, the second command-address pad set is further allocated to a fourth plane among the planes, the first data pad set is further allocated to the third plane, and the second data pad set is further allocated to the fourth plane.

The nonvolatile memory device further includes a third command-address pad set electrically connected to the control logic circuit and allocated to a third plane among the planes, a fourth command-address pad set electrically connected to the control logic circuit and allocated to a fourth plane among the planes, a third data pad set electrically connected to the input/output circuit and allocated to the third plane, and a fourth data pad set electrically connected to the input/output circuit and allocated to the fourth plane.

The first command-address pad set is further allocated to a third plane among the planes, the second command-address pad set is further allocated to a fourth plane among the planes, and the nonvolatile memory device includes a third data pad set allocated to the third plane and a fourth data pad set allocated to the fourth plane.

The first data pad set is further allocated to a fifth plane among the planes, the second data pad set is further allocated to a sixth plane among the planes, the third data pad set is further allocated to a seventh plane among the planes, the fourth data pad set is further allocated to an eighth plane among the planes, the first command-address pad set is further allocated to the fifth and seventh planes, and the second command-address pad set is further allocated to the sixth and eight planes.

The nonvolatile memory device further includes a third command-address pad set electrically connected to the control logic circuit and allocated to the first plane and a fourth command-address pad set electrically connected to the control logic circuit and allocated to the second plane.

Implementations of the present disclosure provide a nonvolatile memory device including a plurality of chips stacked in a vertical direction. At least one of the chips includes at least one plane including a nonvolatile memory, a plurality of command-address pad sets electrically connected to different CA buses from each other, and at least one command-address control circuit electrically connected to the command-address pad sets and the at least one plane and controlling an electrical connection between the command-address pad sets.

Among the chips, a first chip includes a first plane including a nonvolatile memory, a second plane including a nonvolatile memory, a first command-address pad set electrically connected to a first CA bus via a first CA line, a second command-address pad set electrically connected to a second CA bus via a second CA line, a third command-address pad set electrically connected to a third CA bus via a third CA line, a fourth command-address pad set electrically connected to a fourth CA bus via a fourth CA line, a first command-address control circuit electrically connected to the first plane and the first to fourth command-address pad sets and selecting a CA line to be allocated to the first plane among the first to fourth CA lines, and a second command-address control circuit electrically connected to the second plane and the first to fourth command-address pad sets and selecting a CA line to be allocated to the second plane among the first to fourth CA lines.

Among the chips, a second chip includes a third plane including a nonvolatile memory, a fourth plane including a nonvolatile memory, a fifth command-address pad set electrically connected to the first CA bus via the first CA line, a sixth command-address pad set electrically connected to the second CA bus via the second CA line, a seventh command-address pad set electrically connected to the third CA bus via the third CA line, an eighth command-address pad set electrically connected to the fourth CA bus via the fourth CA line, a third command-address control circuit electrically connected to the third plane and the fifth to eighth command-address pad sets and selecting a CA line to be allocated to the third plane among the first to fourth CA lines, and a fourth command-address control circuit electrically connected to the fourth plane and the fifth to eighth command-address pad sets and selecting a CA line to be allocated to the fourth plane among the first to fourth CA lines.

At least one of the first to fourth command-address control circuits includes a plurality of multiplexers.

At least one of the first to fourth command-address control circuits includes a first multiplexer connected to the first CA line and the second CA line and outputting one of the first CA line and the second CA line based on a chip ID, a second multiplexer connected to the third CA line and the fourth CA line and outputting one of the third CA line and the fourth CA line based on the chip ID, and a third multiplexer connected to the first multiplexer and the second multiplexer and outputting one of an output from the first multiplexer and an output from the second multiplexer.

The first command-address control circuit allocates the second CA line among the first to fourth CA lines to the first plane, the second command-address control circuit allocates the fourth CA line among the first to fourth CA lines to the second plane, the third command-address control circuit allocates the first CA line among the first to fourth CA lines to the third plane, and the fourth command-address control circuit allocates the third CA line among the first to fourth CA lines to the fourth plane.

At least two of a first time during which a first command is received via the first CA bus, a second time during which a second command is received via the second CA bus, a third time during which a third command is received via the third CA bus, and a fourth time during which a fourth command is received via the fourth CA bus overlap with each other.

At least one of a size of first data corresponding to the first command, a size of second data corresponding to the second command, a size of third data corresponding to the third command, and a size of fourth data corresponding to the fourth command is smaller than a reference size.

The first command-address control circuit allocates the second CA line among the first to fourth CA lines to the first plane, the second command-address control circuit allocates the second CA line among the first to fourth CA lines to the second plane, the third command-address control circuit allocates the first CA line among the first to fourth CA lines to the third plane, and the fourth command-address control circuit allocates the first CA line among the first to fourth CA lines to the fourth plane.

A first time during which a first command is received via the first CA bus overlaps with a second time during which a second command is received via the second CA bus.

The third CA line and the fourth CA line are floated.

At least one of the first to fourth command-address control circuits includes a first multiplexer connected to the third CA line and the fourth CA line and outputting one of the third CA line and the fourth CA line based on a chip ID and a second multiplexer connected to the first CA line and the first multiplexer and outputting one of the first CA line and an output of the first multiplexer.

The first command-address control circuit allocates the fourth CA line among the first to fourth CA lines to the first plane, the second command-address control circuit allocates the fourth CA line among the first to fourth CA lines to the second plane, the third command-address control circuit allocates the third CA line among the first to fourth CA lines to the third plane, and the fourth command-address control circuit allocates the third CA line among the first to fourth CA lines to the fourth plane.

The first command-address control circuit allocates the first CA line among the first to fourth CA lines to the first plane, the second command-address control circuit allocates the first CA line among the first to fourth CA lines to the second plane, the third command-address control circuit allocates the first CA line among the first to fourth CA lines to the third plane, and the fourth command-address control circuit allocates the first CA line among the first to fourth CA lines to the fourth plane.

At least one of a size of first data corresponding to the first command, a size of second data corresponding to the second command, a size of third data corresponding to the third command, and a size of fourth data corresponding to the fourth command is larger than a reference size.

Among the chips, a first chip includes a first plane including a nonvolatile memory, a second plane including a nonvolatile memory, a first command-address pad set electrically connected to a first CA bus via a first CA line, a second command-address pad set electrically connected to a second CA bus via a second CA line, a third command-address pad set electrically connected to a third CA bus via a third CA line, a fourth command-address pad set electrically connected to a fourth CA bus via a fourth CA line, and a first command-address control circuit electrically connected to the first plane, the second plane, and the first to fourth command-address pad sets and selecting a CA line to be allocated to at least one of the first plane or the second plane among the first to fourth CA lines.

Among the chips, a second chip includes a third plane including a nonvolatile memory, a fourth plane including a nonvolatile memory, a fifth command-address pad set electrically connected to the first CA bus via the first CA line, a sixth command-address pad set electrically connected to the second CA bus via the second CA line, a seventh command-address pad set electrically connected to the third CA bus via the third CA line, an eighth command-address pad set electrically connected to the fourth CA bus via the fourth CA line, and a second command-address control circuit electrically connected to the third plane, the fourth plane, and the fifth to eighth command-address pad sets and selecting a CA line to be allocated to at least one of the third plane or the fourth plane among the first to fourth CA lines.

At least one of the first command-address control circuit or the second command-address control circuit includes at least one NAND gate, at least one OR gate, and at least one multiplexer.

Implementations of the present disclosure provide a nonvolatile memory device including a first chip and a second chip stacked on the first chip and electrically connected to the first chip via a wire, and at least one of the first chip and the second chip includes at least one plane including a nonvolatile memory, a plurality of command-address pad sets electrically connected to different CA buses, and at least one command-address control circuit electrically connected to the command-address pad sets and the at least one plane and controlling an electrical connection between the command-address pad sets.

Implementations of the present disclosure provide a nonvolatile memory device including a first chip and a second chip stacked on the first chip and electrically connected to the first chip by a through-silicon via (TSV). At least one of the first chip and the second chip includes at least one plane including a nonvolatile memory, a plurality of command-address pad sets electrically connected to different CA buses, and at least one command-address control circuit electrically connected to the command-address pad sets and the at least one plane and controlling an electrical connection between the command-address pad sets.

Implementations of the present disclosure provide a storage device comprising a memory controller and any of the described nonvolatile memory devices. The memory device may receive commands from the memory controller through a plurality of command-address buses. The plurality of command-address buses may be electrically connected to the plurality of command-address pad sets. The plurality of command-address buses may be electrically connected to the memory controller. A first command-address bus may be electrically connected to the first command-address pad set. A second command may be electrically connected to the second command-address pad set. The storage device may comprise the plurality of command-address buses.

A reception duration of a command may comprise a time interval during which the command is received. Overlap of reception durations of commands may comprise overlap between the time intervals during which the commands are received.

According to the above, the nonvolatile memory device transmits commands in parallel through plural command-address buses, and thus, data input and output performance is improved.

At least some of the above and other features of the disclosure are set out in the claims.

### BRIEF DESCRIPTION OF THE DRAWINGS

The above and other objects and features of the present disclosure will become apparent by describing in detail implementations thereof with reference to the accompanying drawings.
FIG. 1 is a block diagram illustrating a storage device according to some implementations of the present disclosure.
FIG. 2A is a block diagram illustrating a nonvolatile memory device according to some implementations of the present disclosure in more detail.
FIG. 2B is a circuit diagram illustrating one memory block among a plurality of memory blocks according to some implementations of the present disclosure.
FIGS. 3A, 3B, and 3C are views illustrating nonvolatile memory devices according to implementations of the present disclosure.
FIG. 4 is a view illustrating planes, CA pad sets, and DQ pad sets arranged in a nonvolatile memory device according to some implementations of the present disclosure.
FIGS. 5A and 5B are views explaining reduction of command-address overhead and improvement of data input/output performance according to some implementations of the present disclosure.
FIGS. 6A, 6B, 6C, 6D, 6E, 6F, 6G, 6H, 6I, 6J, and 6K are views illustrating planes, CA pad sets, and DQ pad sets arranged in a nonvolatile memory device according to various implementations of the present disclosure.
FIG. 7 is a block diagram illustrating a storage device according to some implementations of the present disclosure.
FIG. 8 is a block diagram illustrating a nonvolatile memory device of FIG. 7 in more detail.
FIG. 9 is a flowchart illustrating an operation of a nonvolatile memory device according to some implementations of the present disclosure.
FIG. 10 is a flowchart illustrating an operation of a nonvolatile memory device according to some implementations of the present disclosure.
FIG. 11 is a view illustrating planes, CA pad sets, and DQ pad sets arranged in a nonvolatile memory device according to some implementations of the present disclosure.
FIGS. 12A, 12B, and 12C are views illustrating a command-serial mode and a command-parallel mode according to some implementations of the present disclosure.
FIGS. 13A, 13B, and 13C are block diagrams illustrating storage devices according to implementations of the present disclosure.
FIG. 14 is a view illustrating a nonvolatile memory device formed by a pad wiring method according to some implementations of the present disclosure.
FIG. 15 is a view illustrating a CA control circuit of FIG. 14.
FIGS. 16, 17A, 17B, 17C, and 17D are views illustrating an operation of setting the non-volatile memory device of FIG. 14 to enter the command-parallel mode using the CA control circuit of FIG. 15.
FIG. 18 is a view illustrating an electrical connection state of CA lines in a command-parallel mode according to some implementations of the present disclosure.
FIGS. 19, 20A, 20B, 20C, and 20D are views illustrating an operation of setting the non-volatile memory device of FIG. 14 to enter the command-parallel mode using the CA control circuit of FIG. 15.
FIG. 21 is a view illustrating an electrical connection state of CA lines in a command-parallel mode according to some implementations of the present disclosure.
FIG. 22 is a view illustrating an example of a CA control circuit of FIG. 14.
FIGS. 23, 24A, and 24B are views illustrating an operation of setting the non-volatile memory device of FIG. 14 to enter the command-parallel mode using the CA control circuit of FIG. 22.
FIG. 25 is a view illustrating an electrical connection state of CA lines in a command-parallel mode according to some implementations of the present disclosure.
FIGS. 26 and 27 are views illustrating an operation of setting the non-volatile memory device of FIG. 14 to enter the command-serial mode using the CA control circuit of FIG. 22.
FIG. 28 is a view illustrating an electrical connection state of CA lines in a command-serial mode according to some implementations of the present disclosure.
FIG. 29 is a view illustrating a nonvolatile memory device formed by a TSV method according to some implementations of the present disclosure.
FIG. 30 is a view illustrating one of ways of a nonvolatile memory device.
FIG. 31 is a view illustrating a CA control circuit of FIG. 29.
FIGS. 32, 33A, 33B, 33C, and 33D are views illustrating an operation of setting the non-volatile memory device of FIG. 29 to enter a command-parallel mode using the CA control circuit of FIG. 31.
FIGS. 34 and 35 are views illustrating an operation of setting the non-volatile memory device of FIG. 29 to enter a command-serial mode using the CA control circuit of FIG. 31.
FIGS. 36, 37, 38A, 38B, and 38C are views illustrating an operation in which a command requesting a reallocation of a CA pad set is received and an allocation of the CA pad set is changed in response to the request according to some implementations of the present disclosure.
FIG. 39 is a block diagram illustrating a nonvolatile memory device that supports the reallocation of a CA pad set during rerouting according to some implementations of the present disclosure.
FIG. 40A is a view illustrating a first CA control circuit of FIG. 39.
FIG. 40B is a view illustrating a second CA control circuit of FIG. 39.
FIG. 41 is a view illustrating an operation of a CA control circuit when rerouting is not performed.
FIGS. 42 and 43 are views illustrating an operation of a CA control circuit during rerouting.

### DETAILED DESCRIPTION

Below, implementations of the present disclosure will be described in detail and clearly to such an extent that an ordinary one in the art easily implements the disclosure.

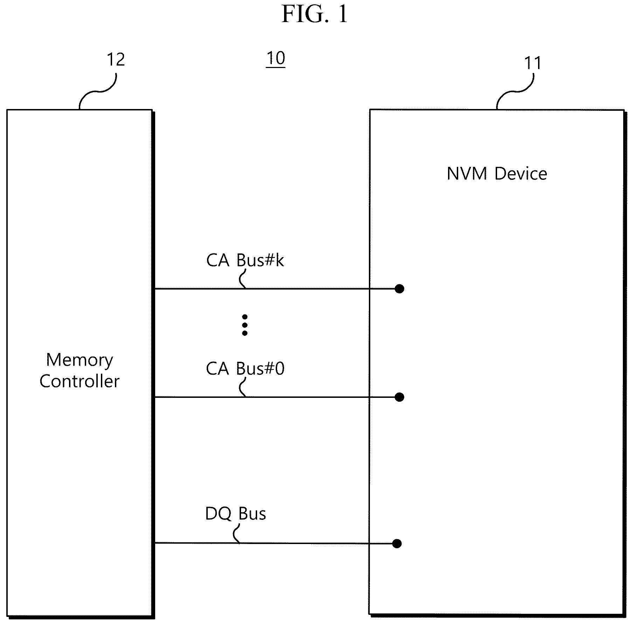

FIG. 1 is a block diagram illustrating a storage device 10 according to some implementations of the present disclosure.

According to some implementations of the present disclosure, a nonvolatile memory device 11 may receive commands from a memory controller 12 through a plurality of command-address buses CA Bus#0 to CA Bus#k. In this case, the commands may be transmitted in parallel from the memory controller 12 to the nonvolatile memory device 11 through the command-address buses CA Bus#0 to CA Bus#k. Accordingly, a command-address overhead may be reduced, and a data input/output performance may be improved even when a data size is relatively small.

Referring to FIG. 1 in more detail, the storage device 10 may include the nonvolatile memory device 11 and the memory controller 12.

The nonvolatile memory device 11 may store data. For example, the nonvolatile memory device 11 may include a plurality of planes, and each of the planes may include memory cells. As an example, the nonvolatile memory device 11 may be implemented to include a nonvolatile memory such as a flash memory. However, this is merely an example, and the present disclosure should not be limited thereto or thereby. According to some implementations, the nonvolatile memory device 11 may be implemented to include MRAM, FRAM, ReRAM, or PCM (Phase Change Memory).

The nonvolatile memory device 11 may perform a data readout operation and a data input operation in response to a request from the memory controller 12.

In some implementations, the nonvolatile memory device 11 may perform the data readout operation in response to the request from the memory controller 12.

For example, the nonvolatile memory device 11 may receive a read command from the memory controller 12 and may perform a read operation on data stored in at least one of the planes in response to the read command.

Also, the nonvolatile memory device 11 may receive an SR command (status read command) from the memory controller 12 and may transmit status information regarding whether the read operation is completed to the memory controller 12 in response to the SR command.

Thereafter, the nonvolatile memory device 11 may receive a data out command from the memory controller 12 and may perform a data output operation to transmit the read-completed data to the memory controller 12 in response to the data out command.

In the present disclosure, a data readout command will be described as including the read command, the SR command, the data out command, and/or addresses corresponding to the read command, the SR command, the data out command.

In some implementations, the nonvolatile memory device 11 may perform the data input operation in response to the request from the memory controller 12.

As an example, the nonvolatile memory device 11 may receive a write command and data from the memory controller 12 and may store the received data in at least one of the planes. In the present disclosure, a data input command will be described as including the write command and/or an address corresponding to the write command.

The memory controller 12 may be electrically connected to the nonvolatile memory device 11. For example, the memory controller 12 may be a controller that supports a DMA (direct memory access) function or a buffer chip function. However, this is merely an example, and the present disclosure should not be limited thereto or thereby. According to some implementations, the memory controller 12 may be a processing unit, such as a GPU or NPU, that communicates with the nonvolatile memory device 11.

The memory controller 12 may request the nonvolatile memory device 11 to perform the data readout operation or the data input operation.

In some implementations, the memory controller 12 may transmit the data readout command to the nonvolatile memory device 11. For example, the memory controller 12 may transmit the read command, the SR command, and the data out command to the nonvolatile memory device 11 to read out data stored in a selected plane among the planes.

In some implementations, the memory controller 12 may transmit the data input command to the nonvolatile memory device 11. For example, the memory controller 12 may transmit the write command to the nonvolatile memory device 11 to store data in at least one plane among the planes.

In some implementations of the present disclosure, the nonvolatile memory device 11 and the memory controller 12 may transmit and receive data through at least one data bus (hereinafter, referred to as a 'DQ bus'). For example, during the data output operation, data may be transmitted from the nonvolatile memory device 11 to the memory controller 12 through one DQ bus. However, this is merely an example, and according to some implementations, the nonvolatile memory device 11 and the memory controller 12 may transmit and receive data through a plurality of DQ buses.

In some implementations of the present disclosure, the nonvolatile memory device 11 and the memory controller 12 may transmit and receive a command and/or an address through at least two of command-address buses CA Bus#0 to CA Bus#k (hereinafter, referred to as a 'CA bus').

In this case, commands and/or addresses may be transmitted in parallel from the memory controller 12 to the nonvolatile memory device 11 through the plurality of CA buses CA Bus#0 to CA Bus#k. For example, during the data output operation, a first data readout command for first data may be transmitted from the memory controller 12 to the nonvolatile memory device 11 through a zeroth CA bus CA Bus#0 among the CA buses CA Bus#0 to CA Bus#k, and a second data readout command for second data may be transmitted from the memory controller 12 to the nonvolatile memory device 11 through a first CA bus among the CA buses CA Bus#0 to CA Bus#k.

In this case, a time during which the first data readout command is transmitted through the zeroth CA bus CA Bus#0 and a time during which the second data readout command is transmitted through the first CA bus may overlap with each other. Accordingly, even when the data size is small, the command-address overhead may be reduced, and the data input/output performance may be improved.

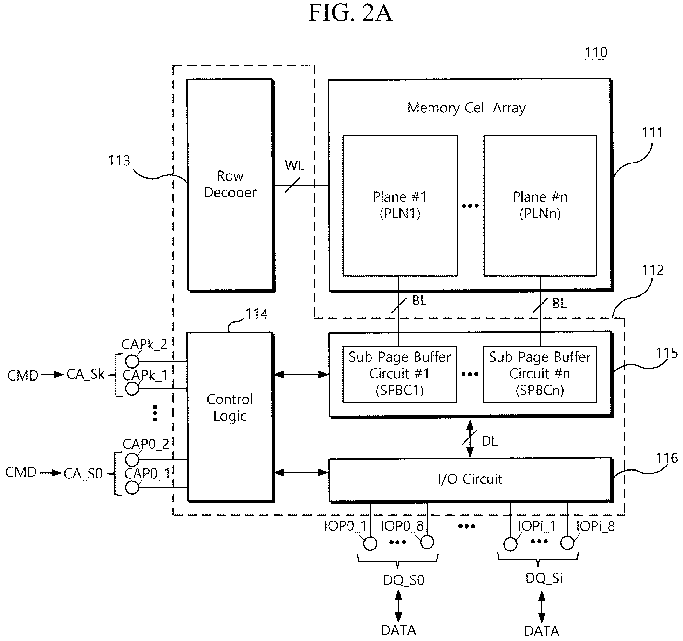

FIG. 2A is a block diagram illustrating a nonvolatile memory device according to some implementations of the present disclosure in more detail. The nonvolatile memory device 110 of FIG. 2A may correspond to the nonvolatile memory device 11 of FIG. 1.

Referring to FIG. 2A, the nonvolatile memory device 110 may include a memory cell array 111 and a peripheral circuit 112, and the peripheral circuit 112 may include a row decoder 113, a control logic circuit 114, a page buffer circuit 115, an I/O circuit 116, command-address pad sets CA_S0 to CA_Sk, and data pad sets DQ_S0 to DQ_Si.

The memory cell array 111 may include at least one plane PLN1 to PLNn. Each of the planes PLN1 to PLNn may include memory blocks. Each of the memory blocks may have a two-dimensional structure or a three-dimensional structure. In the memory block having the two-dimensional structure (or a horizontal structure), memory cells may be formed in a horizontal direction with respect to a substrate. In the memory block having the three-dimensional structure (or a vertical structure), memory cells may be formed in a vertical direction with respect to a substrate.

The memory blocks may include at least one of a single-level cell (SLC) block including SLCs, a multi-level cell (MLC) block including MLCs, a triple-level cell (TLC) block including TLCs, and a quad-level cell (QLC) block including QLCs. Some of the memory blocks included in the memory cell array 111 may be the single-level cell blocks, and other memory blocks may be the multi-level cell blocks or the triple-level cell blocks.

The row decoder 113 may be connected to the memory cell array 111 through row lines RL. The row lines RL may include string selection lines, ground selection lines, word lines, dummy word lines, and GIDL lines.

The page buffer circuit 115 may be connected to the memory cell array 111 through bit lines BL. The page buffer circuit 115 may temporarily store data to be programmed into a selected page or data read from a selected page. The page buffer circuit 115 may include a plurality of sub-page buffer circuits SPBC1 to SPBCn.

The sub-page buffer circuits SPBC1 to SPBCn may be respectively connected to the plurality of planes PLN1 to PLNn through the bit lines BL. For example, a first sub-page buffer circuit SPBC1 may be connected to a first plane PLN1 through the bit lines BL, and an n-th sub-page buffer circuit SPBCn may be connected to an n-th plane PLNn through the bit lines BL.

Each sub-page buffer circuit may include a plurality of page buffers respectively connected to the plurality of bit lines BL. That is, one page buffer may be arranged to correspond to one bit line, and each page buffer may include at least one latch.

The I/O circuit 116 may be connected to the page buffer circuit 115 through data lines DL. The I/O circuit 116 may receive data DATA through at least one data pad set DQ_S0 to DQ_Si (hereinafter, referred to as a 'DQ pad set') and may transfer the received data DATA to the page buffer circuit 115. In addition, the I/O circuit 116 may receive data DATA from the page buffer circuit 115 and may transmit the received data DATA to the memory controller 12 through at least one DQ pad set DQ_S0 to DQ_Si.

In some implementations of the present disclosure, each of one or more DQ pad sets DQ_S0 to DQ_Si may include a plurality of input/output pins. As an example, each DQ pad set may be implemented to include eight input/output pins. For example, a zeroth DQ pad set DQ_S0 may include eight input/output pins IOP0_1 to IOP0_8, and an i-th DQ pad set DQ_Si may also include eight input/output pins IOPi_1 to IOPi_8. However, this is merely an example, and the number of input/output pins corresponding to one DQ pad set should not be particularly limited.

In some implementations of the present disclosure, at least one DQ pad set DQ_S0 to DQ_Si may correspond to one DQ bus (refer to FIG. 1). In other words, at least one DQ pad set DQ_S0 to DQ_Si may be electrically connected to one DQ bus. However, this is merely an example, and according to some implementations, the plurality of DQ pad sets DQ_S0 to DQ_Si may be electrically connected to two or more DQ buses.

The control logic circuit 114 may receive commands from the plurality of command-address pad sets CA_S0 to CA_Sk. The control logic circuit 114 may control an overall operation of the nonvolatile memory device 110 based on the received commands. The control logic circuit 114 may control operation of the nonvolatile memory device 110.

In some implementations of the present disclosure, each of the CA pad sets CA_S0 to CA_Sk may correspond to a plurality of command-address pins (hereinafter, referred to as 'CA pins'). As an example, each CA pad set may be implemented to correspond to two CA pins. For example, a zeroth CA pad set CA_S0 may include two CA pins CAP0_1 and CAP0_2, and a k-th CA pad set CA_Sk may also include two CA pins CAPk_1 and CAPk_2. However, this is merely an example, and the number of CA pins corresponding to one CA pad set should not be limited thereto or thereby.

In some implementations of the present disclosure, each of the CA pad sets CA_S0 to CA_Sk may be electrically connected to different CA buses (refer to FIG. 1). For example, the zeroth CA pad set CA_S0 may be electrically connected to a zeroth CA bus CA Bus#0, and the k-th CA pad set CA_Sk may be electrically connected to a k-th CA bus CA Bus#k. However, this is merely an example, and according to some implementations, plural CA pad sets may be electrically connected to one CA bus.

As described above, the nonvolatile memory device 110 may be implemented to receive a command and/or an address in parallel through the CA pad sets CA_S0 to CA_Sk. Accordingly, even when the data size is small, the command-address overhead may be reduced, and the data input/output performance may be improved.

It will be understood that, in FIG. 2A, a pad or a pin does not refer to a structure of a specific shape. For example, a pad or a pin may refer to a pad, pin, contact, metal bonding, or the like, which includes a conductive material through which signals or data may be transmitted and received.

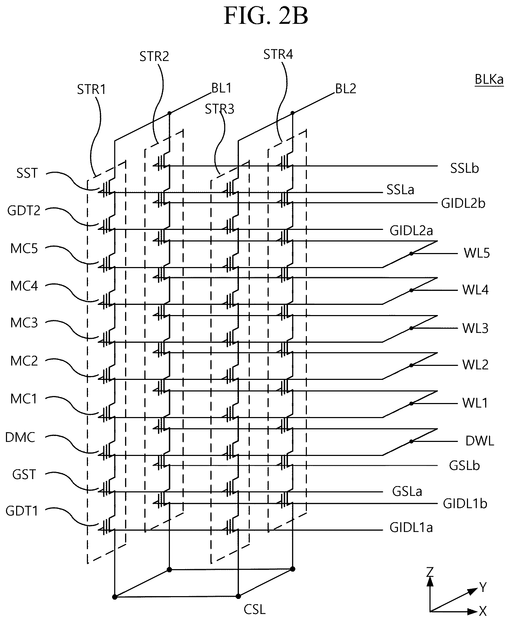

FIG. 2B is a circuit diagram illustrating one memory block among the memory blocks according to some implementations of the present disclosure. The memory block of FIG. 2B may be one of the memory blocks included in the plane of FIG. 2A. For convenience of description, it is assumed that one memory block includes four strings STR1 to STR4.

Referring to FIG. 2B, a memory block BLKa may include the strings STR1 to STR4 that are arranged vertically on a substrate. The strings STR1 to STR4 may be arranged in a first direction (X-axis direction) and a second direction (Y-axis direction).

Strings located in the same column among the strings STR1 to STR4 may be connected to the same bit line. For example, first and second strings STR1 and STR2 may be connected to a first bit line BL1, and third and fourth strings STR3 and STR4 may be connected to a second bit line BL2.

Each of the strings STR1 to STR4 may include a plurality of cell transistors. Each of the cell transistors may be a charge trap flash (CTF) memory cell, but the present disclosure should not be limited thereto or thereby. The cell transistors may be stacked along a third direction (Z-axis direction).

The strings STR1 to STR4 may be commonly connected to a common source line CSL. For example, as shown in FIG. 2B, the common source line CSL may be commonly connected to bottom ends of the strings STR1 to STR4. However, this is merely an example, and it is sufficient that the common source line CSL is electrically connected to the bottom ends of the strings STR1 to STR4, and it is not limited to being physically located at the bottom ends of the strings STR1 to STR4. Hereinafter, for convenience of description, the structure and configuration of a string will be described with reference to a first string STR1. Other strings STR2, STR3, and STR4 may have a structure similar to that of the first string STR1, and a detailed description thereof will be omitted.

The cell transistors may be connected in series between the first bit line BL1 and the common source line CSL. For example, the cell transistors may include GIDL transistors GDT1 and GDT2, a string selection transistor SST, memory cells MC1 to MC5, a dummy memory cell DMC, and ground selection transistors GST.

A first GIDL transistor GDT1 may be arranged at the bottom end of the string STR1. For example, the first GIDL transistor GDT1 may be connected to the common source line CSL at the bottom end of the string STR1. However, this is merely an example, and the present disclosure should not be limited thereto or thereby. A gate of the first GIDL transistor GDT1 may be connected to a first GIDL line GIDL1a.

A second GIDL transistor GDT2 may be arranged at a top end of the string STR1 and may be arranged between the string selection transistor SST and the memory cell MC5. That is, the second GIDL transistor GDT2 may be connected to the first bit line BL1 through the string selection transistor SST. A gate of the second GIDL transistor GDT2 may be connected to a second GIDL line GIDL2a.

FIG. 2B illustrates the structure in which the GIDL transistors GDT1 and GDT2 are respectively arranged at the top and bottom ends of the string STR1. However, this is merely illustrative, and according to some implementations, a GIDL transistor may be arranged only at the top end of the string STR1 or only at the bottom end of the string STR1.

One string selection transistor SST may be arranged at the top end of the string STR1. The string selection transistor SST may be connected to the first bit line BL1 at the top end of the string STR1. A gate of the string selection transistor SST may be connected to a string selection line SSLa. However, this is merely illustrative, and according to some implementations, a plurality of string selection transistors connected in series may be provided between the first bit line BL1 and the second GIDL transistor GDT2.

One ground selection transistor GST may be provided between the dummy memory cell DMC and the first GIDL transistor GDT1. A gate of the ground selection transistor GST may be connected to a ground selection line GSLa. However, this is merely illustrative, and according to some implementations, a plurality of ground selection transistors connected in series may be provided between the dummy memory cell DMC and the first GIDL transistor GDT1.

First to fifth memory cells MC1 to MC5 may be connected in series between the string selection transistor SST and the dummy memory cell DMC. Gates of each of the first to fifth memory cells MC1 to MC5 may be connected to first to fifth word lines WL1 to WL5.

One dummy memory cell DMC may be provided between the first memory cell MC1 and the first GIDL transistor GDT1. The gate of the dummy memory cell DMC may be connected to a dummy word line DWL. However, this is merely illustrative, and according to some implementations, a plurality of dummy memory cells connected in series may be provided between the first memory cell MC1 and the first GIDL transistor GDT1. Alternatively, an additional dummy memory cell may be provided between the string selection transistor SST and the fifth memory cell MC5. In addition, an additional dummy memory cell may be provided between the memory cells MC1 to MC5. Further, the dummy memory cell DMC may not be provided.

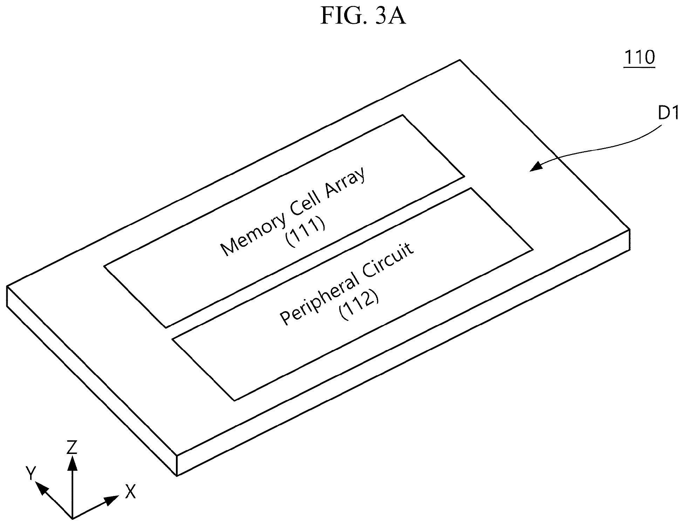

FIGS. 3A to 3C are views illustrating nonvolatile memory devices 110 according to implementations of the present disclosure. The nonvolatile memory device 110 of FIGS. 3A to 3C may correspond to the nonvolatile memory devices 11 and 110 of FIGS. 1 to 2B.

Referring to FIG. 3A, the nonvolatile memory device 110 may be implemented such that a memory cell array 111 and a peripheral circuit 112 are arranged on a single die D1. In this case, the CA pad set and the DQ pad set described with reference to FIG. 2A may be arranged on the die D1. In addition, a command-address control circuit CA CTRL, to be described later, may be arranged on the die D1.

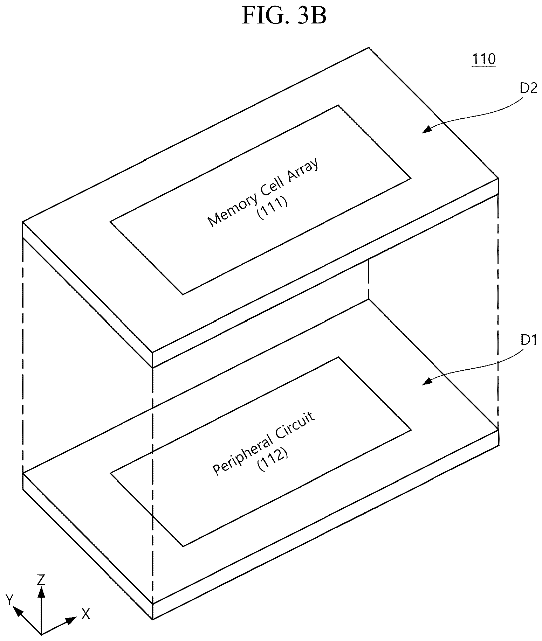

Referring to FIG. 3B, the nonvolatile memory device 110 may include first and second dies D1 and D2 stacked in the vertical direction (e.g., the third direction (Z-axis direction)). A peripheral circuit 112 may be arranged on the first die D1, and a memory cell array 111 may be arranged on the second die D2. The first die D1 and the second die D2 may be connected to each other by a bonding method.

In this case, the CA pad set and the DQ pad set described with reference to FIG. 2A may be arranged on either the first die D1 or the second die D2. In addition, a command-address control circuit CA CTRL, to be described later, may also be arranged on either the first die D1 or the second die D2.

According to some implementations, the CA pad set and the DQ pad set may be arranged on the first die D1, and the command-address control circuit CA CTRL may also be arranged on the first die D1.

According to some implementations, the CA pad set and the DQ pad set may be arranged on the second die D2, and the command-address control circuit CA CTRL may also be arranged on the second die D2.

According to some implementations, the CA pad set and the DQ pad set may be arranged on a die different from a die on which the command-address control circuit CA CTRL is arranged. As an example, the CA pad set and the DQ pad set may be arranged on the second die D2, and the command-address control circuit CA CTRL may be arranged on the first die D1.

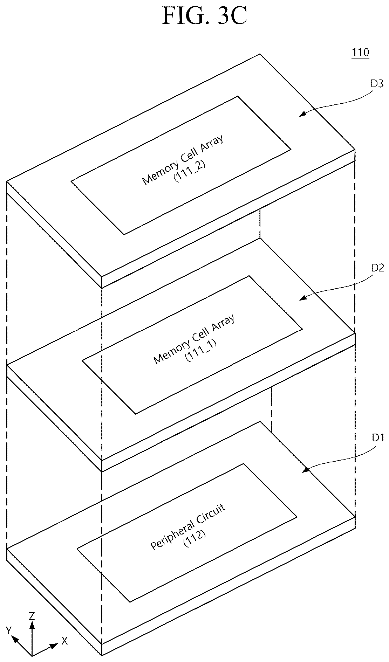

Referring to FIG. 3C, the nonvolatile memory device 110 may include first, second, and third dies D1, D2, and D3 stacked in the vertical direction (e.g., the third direction (Z-axis direction)). For example, a peripheral circuit 112 may be arranged on a first die D1, and memory cell arrays 111_1 and 111_2 may be arranged on second and third dies D2 and D3, respectively. The first die D1 and the second die D2 may be connected to each other by a bonding method, and the second die D2 and the third die D3 may be connected to each other by a bonding method.

In this case, the CA pad set and the DQ pad set described with reference to FIG. 2A may be arranged on one of the first to third dies D1, D2, and D3. In addition, a command-address control circuit CA CTRL, to be described later, may be arranged on one of the first to third dies D1, D2, and D3.

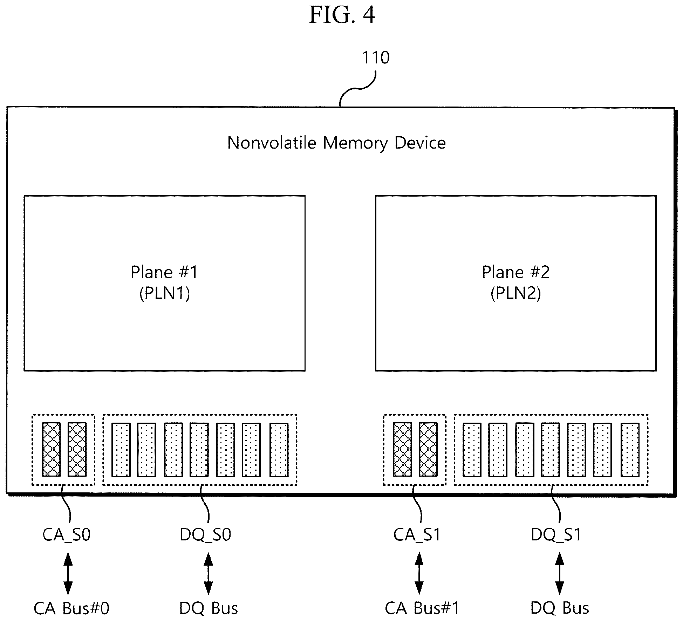

FIG. 4 is a view illustrating the planes, the CA pad sets, and the DQ pad sets arranged in the nonvolatile memory device 110 according to some implementations of the present disclosure. As an example, FIG. 4 illustrates a structure in which two planes PLN1 and PLN2, two CA pad sets CA_S0 and CA_S1, and two DQ pad sets DQ_S0 and DQ_S1 are arranged. For convenience of description, in FIG. 4, it is assumed that the planes, the CA pad sets, and the DQ pad sets are arranged on the same die similar to what is shown in FIG. 3A.

Referring to FIG. 4, the zeroth CA pad set CA_S0 and the zeroth DQ pad set DQ_S0 may correspond to one of the first plane PLN1 and a second plane PLN2. In addition, the first CA pad set CA_S1 and the first DQ pad set DQ_S1 may correspond to the other of the first plane PLN1 and the second plane PLN2.

As an example, it is assumed that the zeroth CA pad set CA_S0 and the zeroth DQ pad set DQ_S0 correspond to the first plane PLN1, and a first CA pad set CA_S1 and a first DQ pad set DQ_S1 correspond to the second plane PLN2.

In this case, the data readout operation and the data input operation for the first plane PLN1 may be performed through the zeroth CA pad set CA_S0 and the zeroth DQ pad set DQ_S0.

For example, the read command, the SR command, and/or the data out command that request data readout for data stored in the first plane PLN1 may be received through the zeroth CA pad set CA_S0. The data stored in the first plane PLN1 may be output to an external device through the zeroth DQ pad set DQ_S0.

For example, the read command, the SR command, and/or the data out command that request data readout for data stored in the second plane PLN2 may be received through the first CA pad set CA_S1. The data stored in the second plane PLN2 may be output to an external device through the first DQ pad set DQ_S1.

In this case, the zeroth CA pad set CA_S0 and the first CA pad set CA_S1 may be electrically connected to different CA buses. For example, the zeroth CA pad set CA_S0 may be electrically connected to the zeroth CA bus CA Bus#0, and the first CA pad set CA_S1 may be electrically connected to the first CA bus CA Bus#1. Accordingly, the data readout command corresponding to the first plane PLN1 and the data readout command corresponding to the second plane PLN2 may be received in parallel from the memory controller 12 (refer to FIG. 1). Accordingly, even when the data size is small, the command-address overhead may be reduced, and the data input/output performance may be improved.

As shown in FIG. 4, the zeroth DQ pad set DQ_S0 and the first DQ pad set DQ_S1 may be electrically connected to the same DQ bus. However, this is merely illustrative, and according to some implementations, the zeroth DQ pad set DQ_S0 and the first DQ pad set DQ_S1 may be electrically connected to different DQ buses.

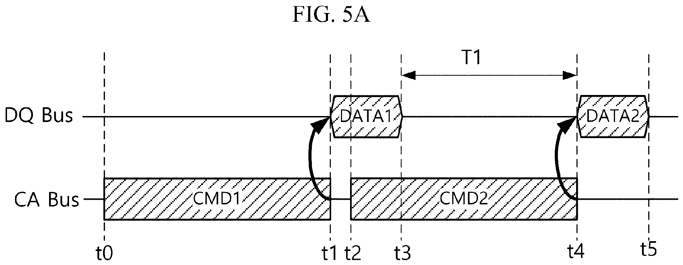

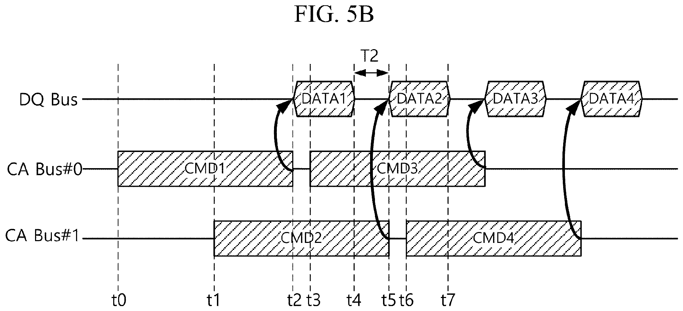

FIGS. 5A and 5B are views explaining the reduction of the command-address overhead and the improvement of the data input/output performance according to some implementations of the present disclosure. As an example, FIG. 5A illustrates a comparative example in which a command-address overhead occurs. FIG. 5B illustrates an example of the present disclosure in which the data readout commands are received through different buses. For convenience of description, the data readout operation will be mainly described below.

Referring to FIG. 5A, a first data readout command CMD1 with respect to first data DATA1 and a second data readout command CMD2 with respect to second data DATA2 are received through the same CA bus.

That is, the first data readout command CMD1 is received through a CA bus during a time interval from t0 to t1. Accordingly, the first data DATA1 is output through a DQ bus during a time interval from t1 to t3.

In addition, the second data readout command CMD2 is received through the same CA bus during a time interval from t2 to t4. Accordingly, the second data DATA2 is output through the DQ bus during a time interval from t4 to t5.

In this case, since sizes of the data DATA1 and DATA2 are relatively smaller than sizes of the commands CMD1 and CMD2, a gap corresponding to a first time T1 occurs between the first data DATA1 and the second data DATA2. This command-address overhead causes a decrease in data input/output performance.

In contrast, since the nonvolatile memory device 110 according to the present disclosure receives the commands in parallel, the command-address overhead may be reduced, and the data input/output performance may be improved.

Referring in more detail to FIGS. 4 and 5B, the first data readout command CMD1 may be received through the zeroth CA bus CA Bus#0 during a time interval from t0 to t1. Accordingly, the first data DATA1 may be output through the DQ bus during a time interval from t2 to t4.

In addition, the second data readout command CMD2 may be received through the first CA bus CA Bus#1 during a time interval from t1 to t5. Accordingly, the second data DATA2 may be output through the DQ bus during a time interval from t5 to t7.

In this manner, a third data readout command CMD3 may be received through the zeroth CA bus CA Bus#0, and a fourth data readout command CMD4 may be received through the first CA bus CA Bus#1.

In this case, the commands CMD1 and CMD3 received through the zeroth CA bus CA Bus#0 may overlap with the commands CMD2 and CMD4 received through the first CA bus CA Bus#1. Therefore, even when the sizes of data DATA1 and DATA2 are relatively smaller than the sizes of commands CMD1 and CMD2, a gap (i.e., T2) between the first data DATA1 and the second data DATA2 may be smaller than the gap (i.e., T1) of FIG. 5A. Consequently, the command-address overhead may be reduced, and the data input/output performance may be improved.

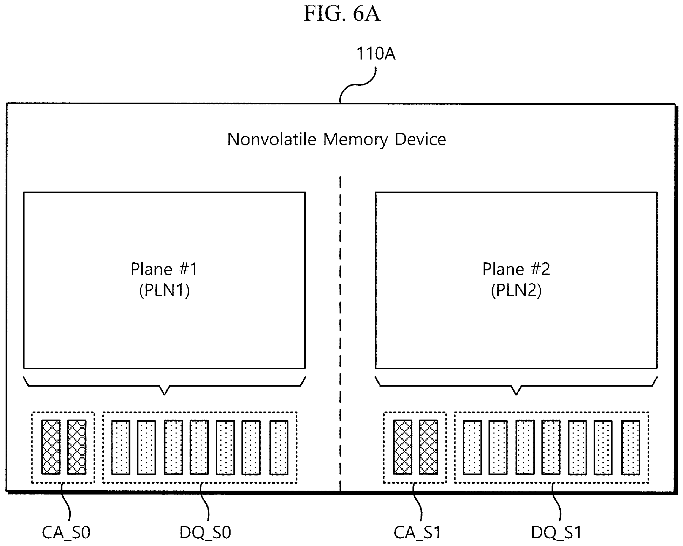

FIGS. 6A to 6K are views illustrating various implementations of the present disclosure in which planes, CA pad sets, and DQ pad sets are arranged in a nonvolatile memory device 110. The nonvolatile memory devices 110A, 110B, 110C, 110D, 110E, 110F, 110G, 110H, 110I, 110J, and 110K of FIGS. 6A to 6K are similar to the nonvolatile memory device 110 of FIG. 4. Accordingly, the same or similar reference numerals denote the same or similar elements, and thus, detailed descriptions of the same or similar elements will be omitted. In addition, for convenience of description, in FIGS. 6A to 6K, it is assumed that the planes, the CA pad sets, and the DQ pad sets are arranged on the same die, similar to FIG. 3A.

Referring to FIGS. 6A to 6K, each of the nonvolatile memory devices 110A to 110K may include at least two CA pad sets. Accordingly, each of the nonvolatile memory devices 110A to 110K may receive commands in parallel, and thus, the command-address overhead may be reduced.

In addition, each of the nonvolatile memory devices 110A to 110K may include at least two CA pad sets and at least two DQ pad sets. In this case, each of the at least two CA pad sets may be assigned to a specific plane, and each of the at least two DQ pad sets may also be assigned to a specific plane. As described above, since the planes corresponding to the CA pad set and the DQ pad set are specified, a layout between the planes and the CA pad sets and/or the DQ pad sets may be optimized. Accordingly, core operations such as the read operations and the write operations may be performed quickly with low power.

To explain in more detail, as shown in FIGS. 6A to 6E, one CA pad set may correspond to one DQ pad set, and one CA pad set may be assigned to one or more planes.

For example, as shown in FIG. 6A, one plane may be assigned per one CA pad set. For instance, the nonvolatile memory device 110A may include two planes PLN1 and PLN2, two CA pad sets CA_S0 and CA_S1, and two DQ pad sets DQ_S0 and DQ_S1.

In this case, a zeroth CA pad set CA_S0 and a zeroth DQ pad set DQ_S0 may be assigned to a first plane PLN1, and a first CA pad set CA_S1 and a first DQ pad set DQ_S1 may be assigned to a second plane PLN2. Accordingly, commands may be transmitted in parallel, and thus, command overhead may be reduced. In addition, the layout may be optimized so that core operation may be performed quickly with low power.

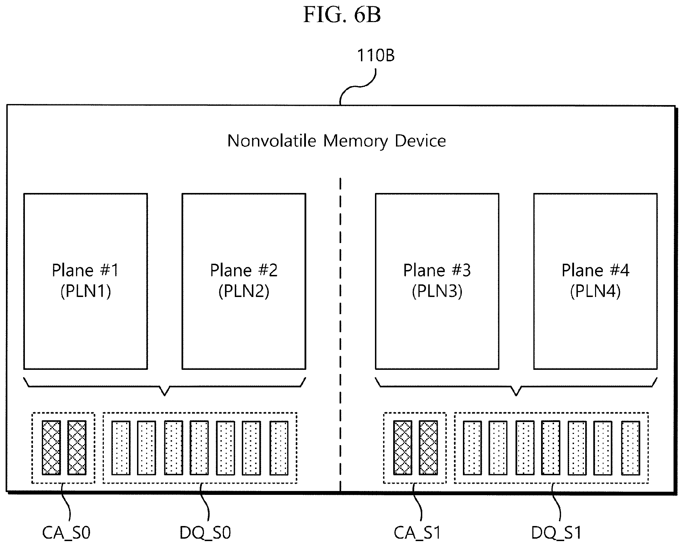

As an example, as shown in FIG. 6B, two planes may be assigned per one CA pad set. For instance, the nonvolatile memory device 110B may include four planes PLN1, PLN2, PLN3, and PLN4, two CA pad sets CA_S0 and CA_S1, and two DQ pad sets DQ_S0 and DQ_S1. A zeroth CA pad set CA_S0 and a zeroth DQ pad set DQ_S0 may be assigned to first and second planes PLN1 and PLN2, and a first CA pad set CA_S1 and a first DQ pad set DQ_S1 may be assigned to third and fourth planes PLN3 and PLN4.

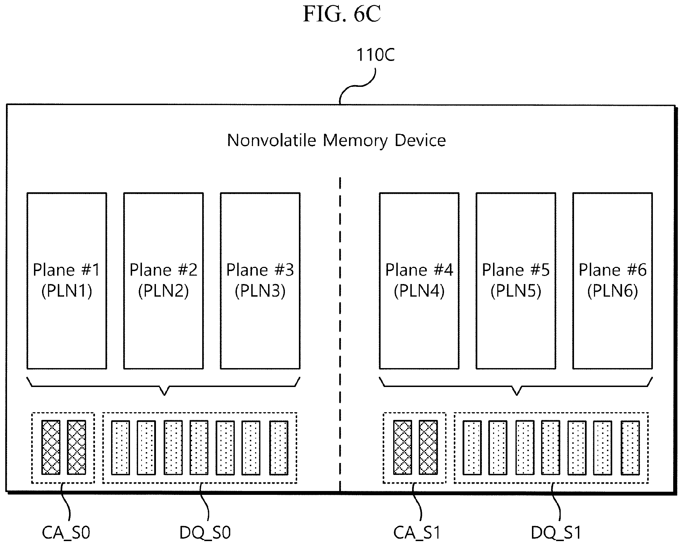

As an example, as shown in FIG. 6C, three planes may be assigned per one CA pad set. For instance, the nonvolatile memory device 110C may include six planes PLN1, PLN2, PLN3, PLN4, PLN5, and PLN6, two CA pad sets CA_S0 and CA_S1, and two DQ pad sets DQ_S0 and DQ_S1. A zeroth CA pad set CA_S0 and a zeroth DQ pad set DQ_S0 may be assigned to first, second, and third planes PLN1, PLN2, and PLN3, and a first CA pad set CA_S1 and a first DQ pad set DQ_S1 may be assigned to fourth, fifth, and sixth planes PLN4, PLN5, and PLN6.

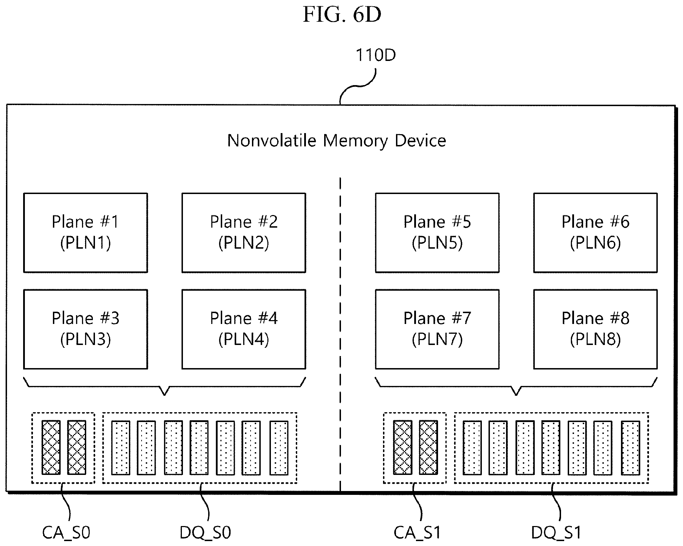

As an example, as shown in FIG. 6D, four planes may be assigned per one CA pad set. For instance, the nonvolatile memory device 110D may include eight planes PLN1, PLN2, PLN3, PLN4, PLN5, PLN6, PLN7, and PLN8, two CA pad sets CA_S0 and CA_S1, and two DQ pad sets DQ_S0 and DQ_S1. A zeroth CA pad set CA_S0 and a zeroth DQ pad set DQ_S0 may be assigned to first, second, third, and fourth planes PLN1, PLN2, PLN3, PLN4, and a first CA pad set CA_S1 and a first DQ pad set DQ_S1 may be assigned to fifth, sixth, seventh, and eighth planes PLN5, PLN6, PLN7, and PLN8.

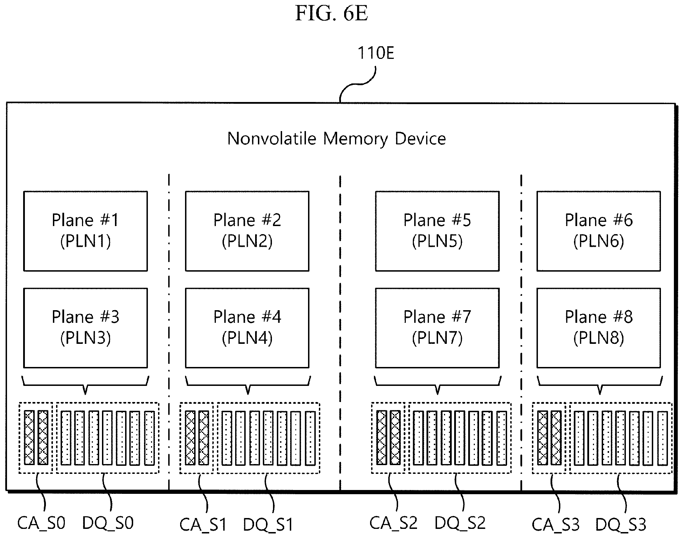

As an example, as shown in FIG. 6E, the nonvolatile memory device 110E may include three or more CA pad sets. For instance, the nonvolatile memory device 110E may include eight planes PLN1, PLN2, PLN3, PLN4, PLN5, PLN6, PLN7, and PLN8, four CA pad sets CA_S0, CA_S1, CA_S2, and CA_S3, and four DQ pad sets DQ_S0, DQ_S1, DQ_S2, and DQ_S3. A zeroth CA pad set CA_S0 and a zeroth DQ pad set DQ_S0 may be assigned to first and third planes PLN1 and PLN3, and a first CA pad set CA_S1 and a first DQ pad set DQ_S1 may be assigned to second and fourth planes PLN2 and PLN4. A second CA pad set CA_S2 and a second DQ pad set DQ_S2 may be assigned to fifth and seventh planes PLN5 and PLN7, and a third CA pad set CA_S3 and a third DQ pad set DQ_S3 may be assigned to sixth and eighth planes PLN6 and PLN8.

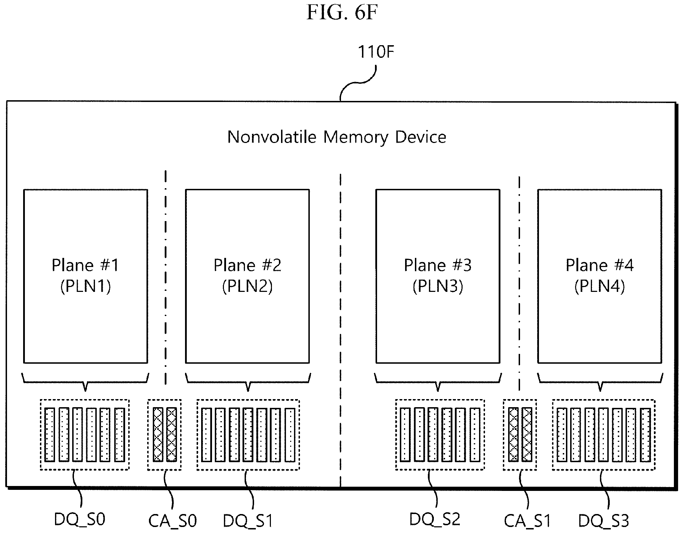

Further, referring to FIGS. 6F to 6I, one CA pad set may correspond to a plurality of DQ pad sets, and one CA pad set may be assigned to a plurality of planes.

For example, as shown in FIG. 6F, two DQ pad sets and two planes may be assigned per one CA pad set. For instance, the nonvolatile memory device 110F may include four planes PLN1, PLN2, PLN3, and PLN4, two CA pad sets CA_S0 and CA_S1, and four DQ pad sets DQ_S0, DQ_S1, DQ_S2, and DQ_S3.

A zeroth CA pad set CA_S0 may be assigned to first and second planes PLN1 and PLN2. The zeroth CA pad set CA_S0 may correspond to zeroth and first DQ pad sets DQ_S0 and DQ_S1. The zeroth and first DQ pad sets DQ_S0 and DQ_S1 may be assigned to the first and second planes PLN1 and PLN2, respectively.

Similarly, a first CA pad set CA_S1 may be assigned to third and fourth planes PLN3 and PLN4. The first CA pad set CA_S1 may correspond to second and third DQ pad sets DQ_S2 and DQ_S3. The second and third DQ pad sets DQ_S2 and DQ_S3 may be assigned to the third and fourth planes PLN3 and PLN4, respectively.

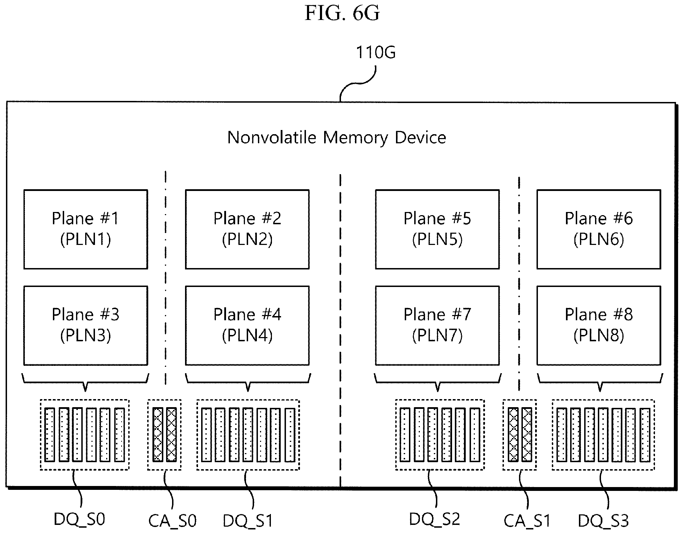

For example, as shown in FIG. 6G, two DQ pad sets and four planes may be assigned per one CA pad set. For instance, the nonvolatile memory device 110G may include eight planes PLN1, PLN2, PLN3, PLN4, PLN5, PLN6, PLN7, and PLN8, two CA pad sets CA_S0 and CA_S1, and four DQ pad sets DQ_S0, DQ_S1, DQ_S2, and DQ_S3.

A zeroth CA pad set CA_S0 may be assigned to first, second, third, and fourth planes PLN1, PLN2, PLN3, and PLN4. The zeroth CA pad set CA_S0 may correspond to zeroth and first DQ pad sets DQ_S0 and DQ_S1. The zeroth DQ pad set DQ_S0 may be assigned to the first and third planes PLN1 and PLN3, and the first DQ pad set DQ_S1 may be assigned to the second and fourth planes PLN2 and PLN4. Similarly, the zeroth CA pad set CA_S1 may be assigned to fifth to eighth planes PLN5, PLN6, PLN7, and PLN8.

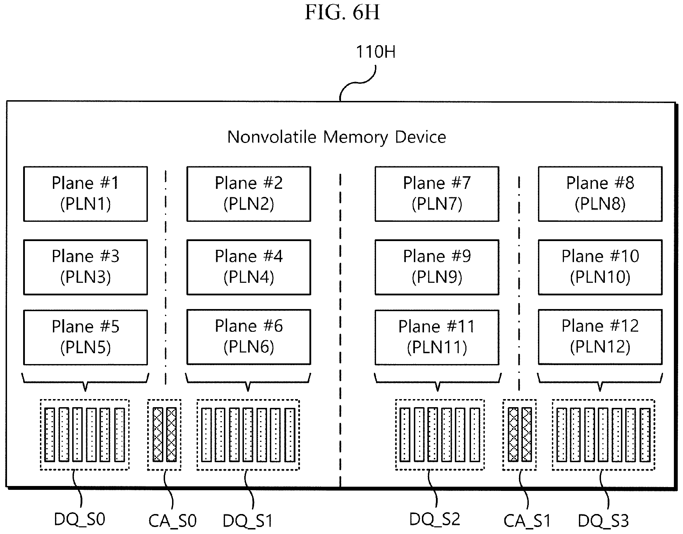

For example, as shown in FIG. 6H, two DQ pad sets and six planes may be assigned per one CA pad set. For instance, the nonvolatile memory device 110H may include twelve planes PLN1, PLN2, PLN3, PLN4, PLN5, PLN6, PLN7, PLN8, PLN9, PLN10, PLN11, and PLN12, two CA pad sets CA_S0 and CA_S1, and four DQ pad sets DQ_S0, DQ_S1, DQ_S2, and DQ_S3.

A zeroth CA pad set CA_S0 may be assigned to first, second, third, fourth, fifth, and sixth planes PLN1, PLN2, PLN3, PLN4, PLN5, and PLN6. The zeroth CA pad set CA_S0 may correspond to zeroth and first DQ pad sets DQ_S0 and DQ_S1. The zeroth DQ pad set DQ_S0 may be assigned to the first, third, and fifth planes PLN1, PLN3, and PLN5, and the first DQ pad set DQ_S1 may be assigned to the second, fourth, and sixth planes PLN2, PLN4, and PLN6. Similarly, a first CA pad set CA_S1 may be assigned to seventh, eighth, ninth, tenth, eleventh, and twelfth planes PLN7, PLN8, PLN9, PLN10, PLN11, and PLN12.

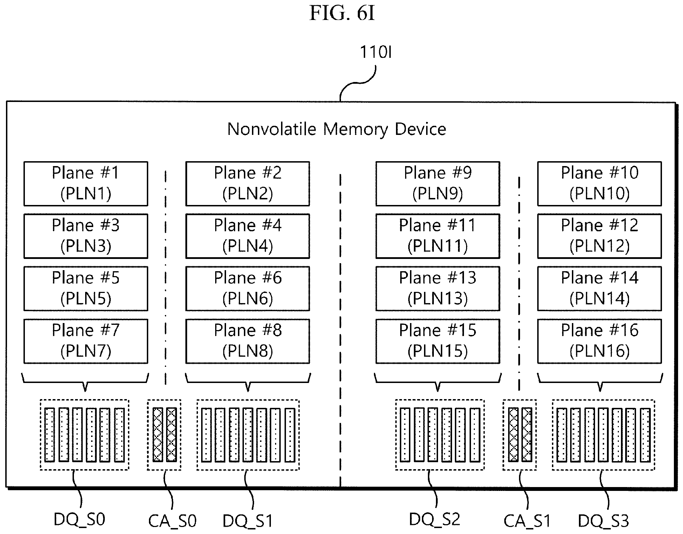

For example, as shown in FIG. 6I, two DQ pad sets and eight planes may also be assigned per one CA pad set. For instance, the nonvolatile memory device 110I may include sixteen planes PLN1, PLN2, PLN3, PLN4, PLN5, PLN6, PLN7, PLN8, PLN9, PLN10, PLN11, PLN12, PLN13, PLN14, PLN15, and PLN16, two CA pad sets CA_S0 and CA_S1, and four DQ pad sets DQ_S0, DQ_S1, DQ_S2, and DQ_S3.

A zeroth CA pad set CA_S0 may be assigned to first, second, third, fourth, fifth, sixth, seventh, and eighth planes PLN1, PLN2, PLN3, PLN4, PLN5, PLN6, PLN7, and PLN8. The zeroth CA pad set CA_S0 may correspond to zeroth and first DQ pad sets DQ_S0 and DQ_S1. The zeroth DQ pad set DQ_S0 may be assigned to the first, third, fifth, and seventh planes PLN1, PLN3, PLN5, and PLN7, and the first DQ pad set DQ_S1 may be assigned to the second, fourth, sixth, and eighth planes PLN2, PLN4, PLN6, and PLN8. Similarly, a first CA pad set CA_S1 may be assigned to ninth, tenth, eleventh, twelfth, thirteenth, and fourteenth, fifteenth, and sixteenth planes PLN9, PLN10, PLN11, PLN12, PLN13, PLN14, PLN15, and PLN16.

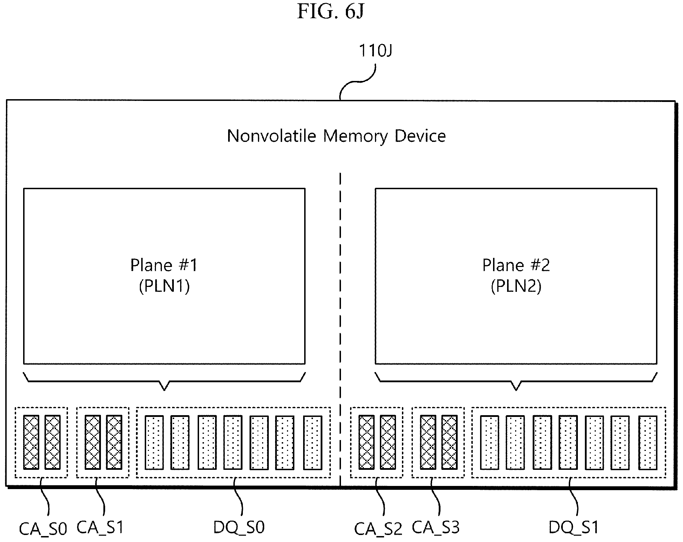

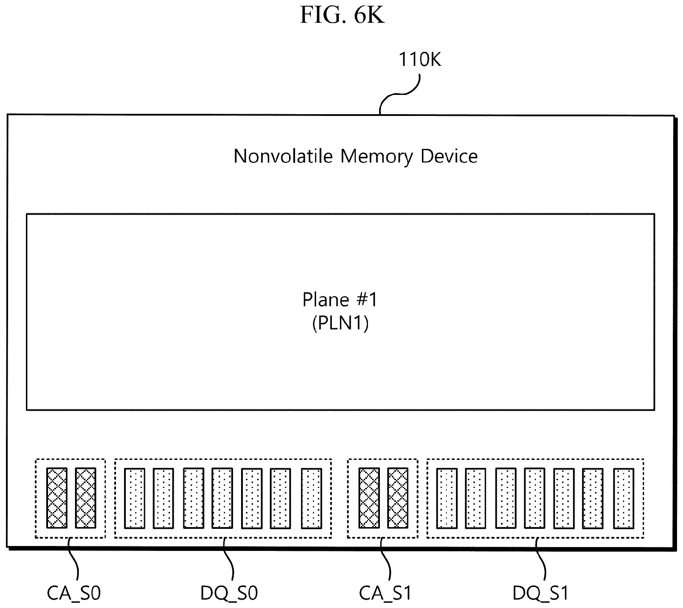

Referring to FIGS. 6J and 6K, a plurality of CA pad sets may be assigned to one plane.

For example, as shown in FIG. 6J, one DQ pad set and one plane may be assigned per two CA pad sets. For instance, the nonvolatile memory device 110J may include two planes PLN1 and PLN2, four CA pad sets CA_S0, CA_S1, CA_S2, and CA_S3, and two DQ pad sets DQ_S0 and DQ_S1.

Zeroth and first CA pad sets CA_S0 and CA_S1 may be assigned to a first plane PLN1. The zeroth and first CA pad sets CA_S0 and CA_S1 may correspond to a zeroth DQ pad set DQ_S0. The zeroth DQ pad set DQ_S0 may be assigned to the first plane PLN1. Similarly, second and third CA pad sets CA_S2 and CA_S3 may be assigned to a second plane PLN2.

For example, as shown in FIG. 6K, the nonvolatile memory device 110K may include one plane, and one DQ pad set and one plane may be assigned per two CA pad sets.

As described above, each of the nonvolatile memory devices 110A to 110K according to the present disclosure may receive the commands in parallel, and thus, the command-address overhead may be reduced. In addition, each of the nonvolatile memory devices 110A to 110K according to the present disclosure may include at least two CA pad sets and at least two DQ pad sets, and each CA pad set and each DQ pad set may be assigned to a specific plane. Accordingly, the layout between the planes and the CA pad sets and/or DQ pad sets may be optimized.

In some implementations of the present disclosure, the planes to which each CA pad set and/or each DQ pad set are assigned may be reconfigured based on a data size. This will be described in more detail below.

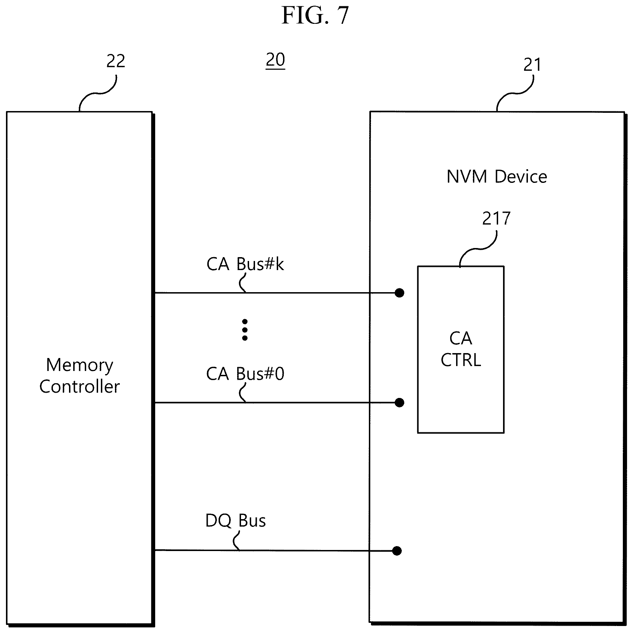

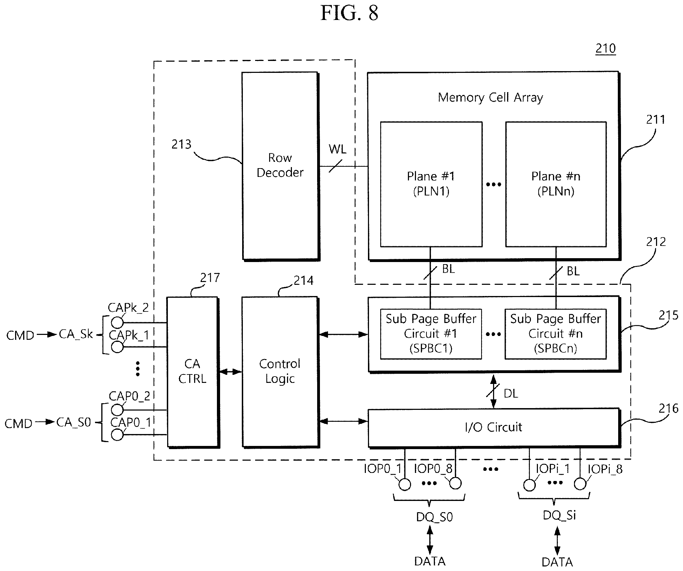

FIG. 7 is a block diagram illustrating a storage device 20 according to some implementations of the present disclosure. FIG. 8 is a block diagram illustrating a nonvolatile memory device of FIG. 7 in more detail. The storage device 20 of FIG. 7 and the nonvolatile memory device 210 of FIG. 8 are similar to the storage device 10 of FIG. 1 and the nonvolatile memory device 110 of FIG. 2A. Accordingly, in FIGS. 7 and 8, the same or similar reference numerals denote the same or similar elements in FIGS. 1 and 2A, and thus, detailed descriptions of the same elements will be omitted.

The nonvolatile memory devices 21 and 210 according to the present disclosure may receive commands in parallel from a memory controller 22 through a plurality of command-address buses CA Bus#0 to CA Bus#k. Accordingly, a command-address overhead may be reduced and a data input/output performance may be improved even when the data size is relatively small.

Additionally, according to the present disclosure, the nonvolatile memory devices 21 and 210 may reconfigure planes to which CA pad sets are assigned based on the data size. Accordingly, the data input/output performance may be further improved.

Referring to FIGS. 7 and 8, compared to the nonvolatile memory devices 11 and 110 of FIGS. 1 and 2A, the nonvolatile memory devices 21 and 210 may further include a command-address control circuit (hereinafter, referred to as a 'CA control circuit') 217.

The CA control circuit 217 may be electrically connected to a plurality of CA pad sets CA_S0 to CA_Sk. The CA control circuit 217 may receive commands CMD through the CA pad sets CA_S0 to CA_Sk.

The CA pad sets CA_S0 to CA_Sk may correspond to the CA buses CA Bus#0 to CA Bus#k, respectively. For example, a zeroth CA pad set CA_S0 may correspond to a zeroth CA bus CA Bus#0, and a k-th CA pad set CA_Sk may correspond to a k-th CA bus CA Bus#k.

In some implementations of the present disclosure, the CA control circuit 217 may reconfigure the planes assigned to the CA pad sets based on the data size. In other words, based on the data size, the CA control circuit 217 may reconfigure each of the planes PLN1 to PLNn to correspond to a different CA pad set or may reconfigure some of the planes PLN1 to PLNn to correspond to the same CA pad set.

For example, when the data size is relatively small, the CA control circuit 217 may assign each of the planes PLN1 to PLNn to a different CA pad set. In this case, the memory controller 22 and the nonvolatile memory devices 21 and 210 may transmit and receive commands and/or addresses through a relatively large number of CA buses.

For example, when the data size is relatively large, the CA control circuit 217 may assign at least two planes of the planes PLN1 to PLNn to the same CA pad set. In other words, one CA pad set may be assigned to at least two planes. In this case, the memory controller 22 and the nonvolatile memory devices 21 and 210 may transmit and receive commands and/or addresses through a relatively small number of CA buses.

Accordingly, since the nonvolatile memory devices 21 and 210 according to the present disclosure may reconfigure the planes to which the CA pad sets are assigned based on the data size, the data input/output performance may further be improved.

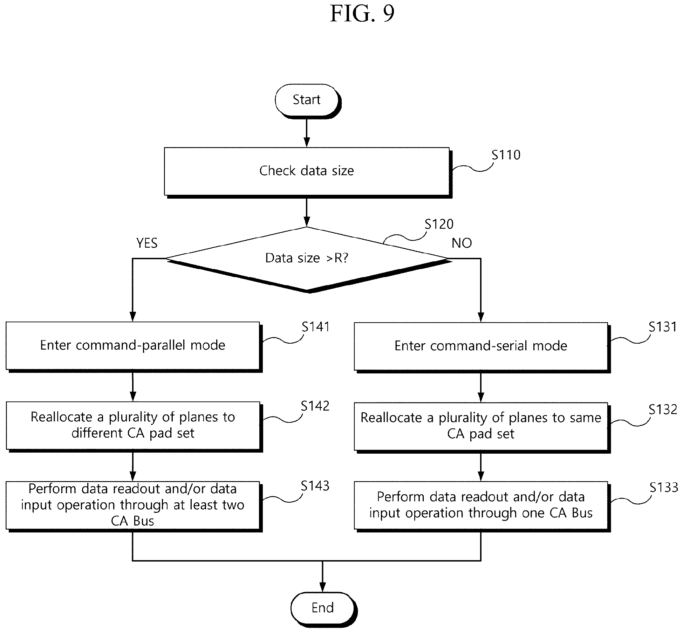

In some implementations of the present disclosure, a decision to reconfigure the allocation of the CA pad set based on the data size may be performed in the nonvolatile memory devices 21 and 210. For example, the nonvolatile memory devices 21 and 210 may reconfigure the planes to which the CA pad sets are assigned based on the size of the received data. This will be described in more detail below with reference to FIG. 9.

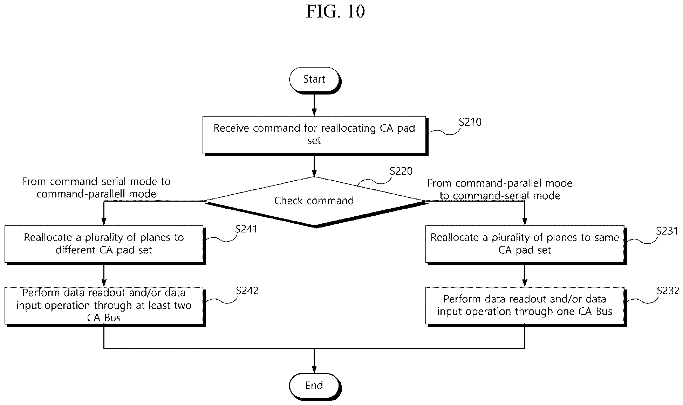

Alternatively, in some implementations of the present disclosure, the decision to reconfigure the allocation of the CA pad set based on the data size may be performed in the memory controller 22. For example, the memory controller 22 may transmit a command to the nonvolatile memory devices 21 and 210 to reconfigure the CA pad set based on the size of the data to be transmitted, and the nonvolatile memory devices 21 and 210 may reconfigure the planes to which the CA pad sets are assigned based on the command. This will be described in more detail below with reference to FIGS. 10 and 36 to 38C.

FIG. 9 is a flowchart illustrating an operation of the nonvolatile memory device according to some implementations of the present disclosure. For example, FIG. 9 illustrates an example in which the nonvolatile memory device checks the data size and reconfigures the plane to which the CA pad set is allocated based on the checked data size.

In operation S110, the data size may be checked. For example, a control logic circuit 214 (refer to FIG. 8) of the nonvolatile memory device 210 (refer to FIG. 8) may check the data size during the data output operation and/or the data size during the data input operation.

In operation S120, it may be checked whether the data size is larger than a reference size. For example, the control logic circuit 214 may check whether the size of data in the data input and output operations is larger than the reference size, which is previously determined.

When the data size is determined to be smaller than the reference size, an operation S131 may be performed.

In operation S131, the nonvolatile memory device 210 may enter a command-serial mode.

In operation S132, the nonvolatile memory device 210 may reallocate the plural planes to the same CA pad set. In other words, one CA pad set may be reallocated to the plural planes. In this case, the nonvolatile memory device 210 may be electrically connected to the memory controller 22 through one CA bus corresponding to one CA pad set.

In step S133, the nonvolatile memory device 210 may perform the data readout operation and/or the data input operation through one CA bus. In other words, data may be transmitted and received serially between the nonvolatile memory device 210 and the memory controller 22 through one CA bus. The command-serial mode may be a mode of operation of the nonvolatile memory device 210 in which data is transmitted serially between the nonvolatile memory device 210 and the memory controller 22. Serial transmission of data may utilize only a single bus.

As described above, when the data size is smaller than the reference size, the commands may be transmitted and received serially through one CA bus, and accordingly, power consumption may be reduced.

When the data size is determined to be larger than the reference size in operation S120, an operation S141 may be performed.

In operation S141, the nonvolatile memory device 210 may enter a command-parallel mode.

In operation S142, the nonvolatile memory device 210 may reallocate the plural planes to different CA pad sets. In other words, different CA pad sets may be reallocated to different planes. In this case, the nonvolatile memory device 210 may be electrically connected to the memory controller 22 through at least two CA buses corresponding to at least two CA pad sets.

In operation S143, the nonvolatile memory device 210 may perform the data readout operation and/or the data input operation through the at least two CA buses. In other words, data may be transmitted and received in parallel between the nonvolatile memory device 210 and the memory controller 22 through at least two CA buses. The command-parallel mode may be a mode of operation of the nonvolatile memory device 210 in which data is transmitted in parallel between the nonvolatile memory device 210 and the memory controller 22. Serial transmission of data may utilize at least two CA buses.

As described above, when the data size is larger than the reference size, commands may be transmitted and received in parallel through plural CA buses, and accordingly, the command-address overhead may be reduced.

Consequently, the nonvolatile memory device 210 according to the present disclosure may selectively support the command-serial mode and/or the command-parallel mode based on the data size.

FIG. 10 is a flowchart illustrating an operation of the nonvolatile memory device according to some implementations of the present disclosure. For example, FIG. 10 illustrates an example in which the memory controller transmits the command to reallocate the CA pad set based on the data size and the nonvolatile memory device changes the mode based on the command. The operation of the nonvolatile memory device in FIG. 10 is similar to that of FIG. 9. Therefore, descriptions of the same or similar elements will be omitted.

In operation S210, the nonvolatile memory device 210 (refer to FIG. 8) may receive a command requesting the reallocation of the CA pad set from the memory controller 22 (refer to FIG. 7). For example, the nonvolatile memory device 210 may identify that the command is the command requesting the reallocation of the CA pad set based on a header of the received command.

In operation S220, the nonvolatile memory device 210 may check the received command. For example, the nonvolatile memory device 210 may check the plane to which the CA pad set is allocated based on a body of the received command.

In a case where the command is a command requesting the reallocation of the planes to the same CA pad set, an operation mode of the nonvolatile memory device 210 may be changed from the command-parallel mode to the command-serial mode. In this case, operation S231 may be performed.

In operation S231, the nonvolatile memory device 210 may reallocate the planes to the same CA pad set.

In operation S232, the nonvolatile memory device 210 may perform the data readout operation and/or the data input operation through one CA bus.

In a case where the command is a command requesting the reallocation of different planes to different CA pad sets, the operation mode of the nonvolatile memory device 210 may be changed from the command-serial mode to the command-parallel mode. In this case, operation S241 may be performed.

In operation S241, the nonvolatile memory device 210 may reallocate plural planes to different CA pad sets.

In operation S242, the nonvolatile memory device 210 may perform the data readout operation and/or the data input operation through at least two CA buses.

Consequently, the nonvolatile memory device 210 according to the present disclosure may selectively support the command-serial mode and/or the command-parallel mode based on the data size.

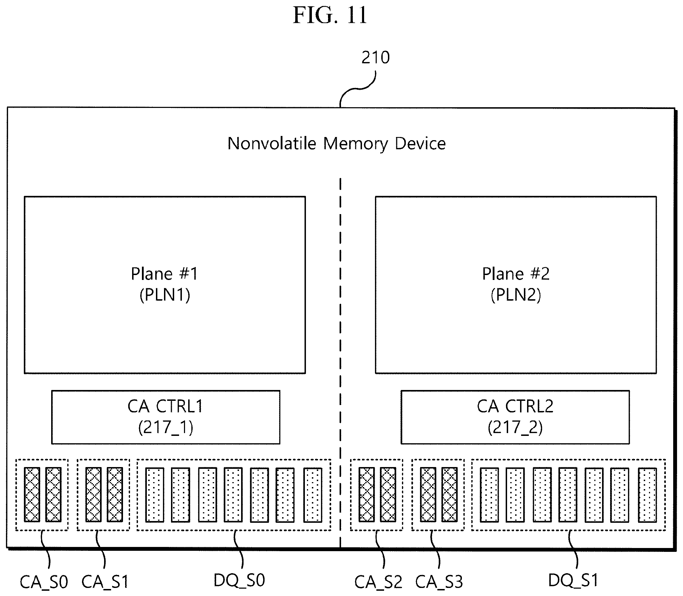

FIG. 11 is a view illustrating planes, CA pad sets, and DQ pad sets arranged in a nonvolatile memory device 210 according to some implementations of the present disclosure. For example, FIG. 11 illustrates a structure in which two planes PLN1 and PLN2, two CA pad sets CA_S0 and CA_S1, two DQ pad sets DQ_S0 and DQ_S1, and two CA control circuits 217_1 and 217_2 are arranged. The nonvolatile memory device 210 in FIG. 11 is similar to that of FIGS. 4 and 6J. Therefore, the same or similar reference numerals denote the same or similar elements of FIGS. 4 and 6J, and thus, detailed descriptions of the same elements will be omitted.

Referring to FIG. 11, the nonvolatile memory device 210 may further include a first CA control circuit 217_1 and a second CA control circuit 217_2.

The first CA control circuit 217_1 may be electrically connected to a first plane PLN1 and zeroth to third CA pad sets CA_S0 to CA_S3. Based on the control of the control logic circuit 214 (refer to FIG. 8), the first CA control circuit 217_1 may determine the CA pad set to be assigned to the first plane PLN1 among the zeroth to third CA pad sets CA_S0 to CA_S3.

The second CA control circuit 217_2 may be electrically connected to a second plane PLN2 and the zeroth to third CA pad sets CA_S0 to CA_S3. Based on the control of the control logic circuit 214, the second CA control circuit 217_2 may determine the CA pad set to be assigned to the second plane PLN2 among the zeroth to third CA pad sets CA_S0 to CA_S3.

In FIG. 11, the first CA control circuit 217_1 and the second CA control circuit 217_2 are illustrated as being arranged on the same die. However, this is merely an example, and the present disclosure should not be limited thereto or thereby. For example, similar to what is shown in FIGS. 3B and 3C, the first CA control circuit 217_1 and the second CA control circuit 217_2 may be arranged on a die on which a peripheral circuit is arranged.

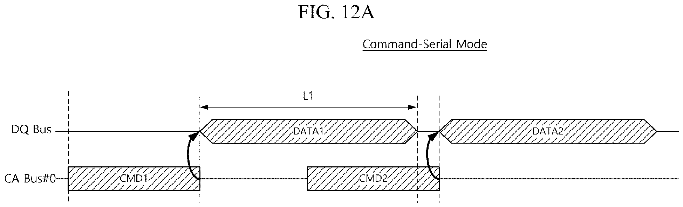

FIGS. 12A to 12C are views illustrating the command-serial mode and the command-parallel mode according to some implementations of the present disclosure. FIGS. 12A to 12C are similar to FIG. 5. Therefore, redundant descriptions will be omitted. For convenience of explanation, a data readout operation will be mainly described below. In addition, data sizes will be denoted by 'L1', 'L2', and 'L3', and it will be assumed that the size of L1 is the largest and the size of L3 is the smallest.

Referring to FIGS. 11 and 12A, the size of data DATA1 and DATA2 is 'L1', which is larger than the size of data readout commands CMD1 and CMD2. In this case, the nonvolatile memory device 210 (refer to FIG. 8) may enter the command-serial mode that uses one CA bus.

In some implementations, the first CA control circuit 217_1 may assign the zeroth CA pad set CA_S0 to the first plane PLN1. In other words, the first CA control circuit 217_1 may determine the zeroth CA pad set CA_S0 as the CA pad set to be assigned to the first plane PLN1 among the zeroth to third CA pad sets CA_S0 to CA_S3.

In addition, the second CA control circuit 217_2 may assign the zeroth CA pad set CA_S0 to the second plane PLN2. In other words, the second CA control circuit 217_2 may determine the zeroth CA pad set CA_S0 as the CA pad set to be assigned to the second plane PLN2 among the zeroth to third CA pad sets CA_S0 to CA_S3.

Accordingly, only the zeroth CA pad set CA_S0 may be selected in the command-serial mode. Therefore, the nonvolatile memory device 210 and the memory controller 22 may receive the commands through the zeroth CA bus CA Bus#0.

In this case, since the size of the data DATA1 and DATA2 is larger than the size of the data readout commands CMD1 and CMD2, a problem due to the command overhead may not occur. Furthermore, since one CA bus is used, power consumption may be reduced.

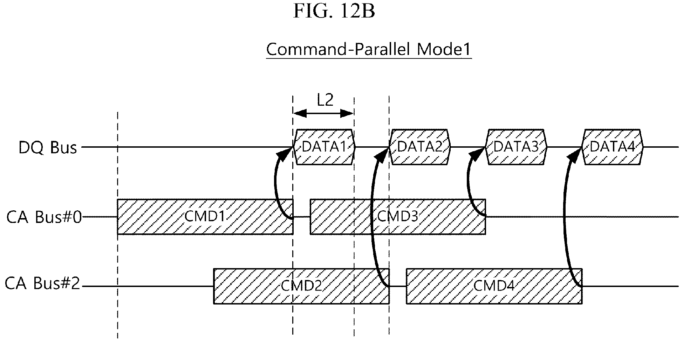

Referring to FIGS. 11 and 12B, the size of data DATA1, DATA2, DATA3, and DATA4 is 'L2', which is relatively smaller than the size of data readout commands CMD1, CMD2, CMD3, and CMD4. In this case, the nonvolatile memory device 210 may enter a first command-parallel mode that uses a relatively large number of CA buses.

In some implementations, the first CA control circuit 217_1 may assign the zeroth CA pad set CA_S0 to the first plane PLN1. In other words, the first CA control circuit 217_1 may determine the zeroth CA pad set CA_S0 as the CA pad set to be assigned to the first plane PLN1 among the zeroth to third CA pad sets CA_S0 to CA_S3.

The second CA control circuit 217_2 may assign the second CA pad set CA_S2 to the second plane PLN2. In other words, the second CA control circuit 217_2 may determine the second CA pad set CA_S2 as the CA pad set to be assigned to the second plane PLN2 among the zeroth to third CA pad sets CA_S0 to CA_S3.

Accordingly, the zeroth and second CA pad sets CA_S0 and CA_S2 may be selected in the first command-parallel mode. Therefore, the nonvolatile memory device 210 and the memory controller 22 may receive commands through two CA buses CA Bus#0 and CA Bus#2.

As a result, even when the size of the data is relatively small, the nonvolatile memory device according to the present disclosure may not only reduce the command overhead by receiving the commands in parallel, but also appropriately adjust power consumption.

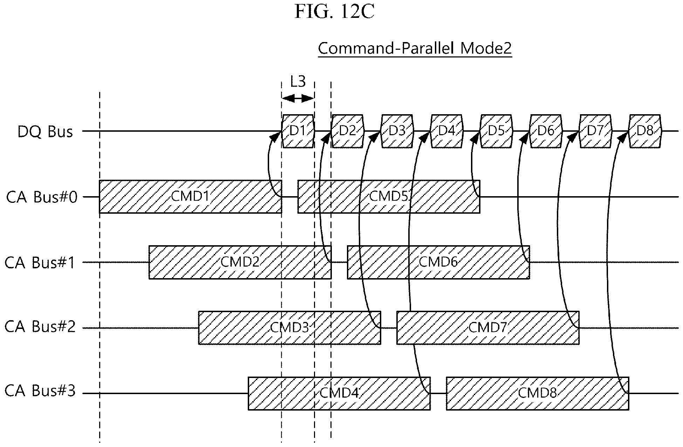

Referring to FIGS. 11 and 12C, the size of data D1 to D8 is 'L3', which is the smallest. In this case, the nonvolatile memory device 210 may enter a second command-parallel mode that uses the largest number of CA buses.

In some implementations, the first CA control circuit 217_1 may assign the zeroth and first CA pad sets CA_S0 and CA_S1 to the first plane PLN1. In other words, the first CA control circuit 217_1 may determine the zeroth and first CA pad sets CA_S0 and CA_S1 as the CA pad set to be assigned to the first plane PLN1 among the zeroth to third CA pad sets CA_S0 to CA_S3.

The second CA control circuit 217_2 may assign the second and third CA pad sets CA_S2 and CA_S3 to the second plane PLN2. In other words, the second CA control circuit 217_2 may determine the second and third CA pad sets CA_S2 and CA_S3 as the CA pad set to be assigned to the second plane PLN2 among the zeroth to third CA pad sets CA_S0 to CA_S3.

Accordingly, the zeroth to third CA pad sets CA_S0, CA_S1, CA_S2, and CA_S3 may be selected in the second command-parallel mode. Therefore, the nonvolatile memory device 210 and the memory controller 22 may receive the commands through four CA buses CA Bus#0, CA Bus#1, CA Bus#2, and CA Bus#3.

Consequently, even when the size of the data is small, the nonvolatile memory device according to the present disclosure may reduce the command overhead by receiving the commands in parallel.

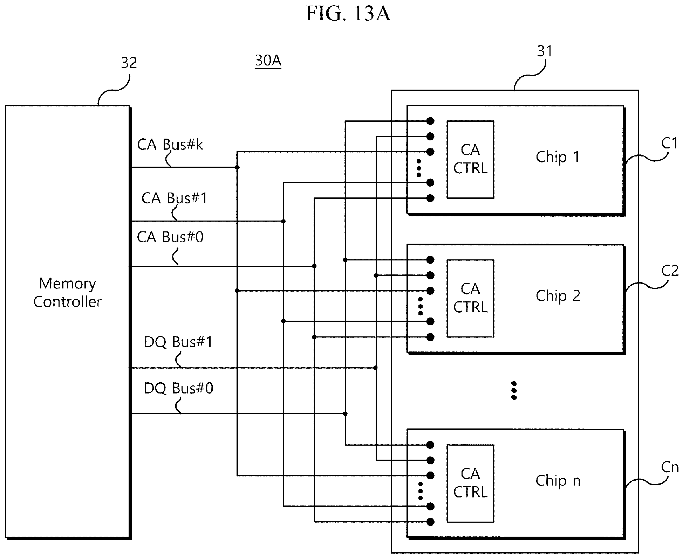

FIGS. 13A to 13C are block diagrams illustrating storage devices 30A, 30B, and 30C according to implementations of the present disclosure. The storage devices 30A, 30B, and 30C of FIGS. 13A to 13C are similar to the storage devices 10 and 20 in FIGS. 1 and 7. Therefore, the same or similar elements are denoted by the same or similar reference numerals, and redundant descriptions will be omitted.

Referring to FIGS. 13A to 3C, a nonvolatile memory device 31 according to some implementations may include a plurality of chips C1 to Cn. The chips C1 to Cn may be stacked in the vertical direction and may be connected to each other through a pad wiring method or a through-silicon via (TSV) wiring method. Each of the chips C1 to Cn may correspond to the nonvolatile memory devices 11, 21, 110, and 210 described above.

Each of the chips C1 to Cn may include a plurality of CA pad sets. For example, a first chip C1 may include zeroth to k-th CA pad sets, and an n-th chip Cn may also include zeroth to k-th CA pad sets.

The CA pad sets of each of the chips C1 to Cn may share the same CA bus. For example, the zeroth CA pad sets of each of the chips C1 to Cn may be electrically connected to a zeroth CA bus CA Bus#0. The k-th CA pad sets of each of the chips C1 to Cn may be electrically connected to a k-th CA bus CA Bus#k.

Each of the chips C1 to Cn may include at least one DQ pad set.

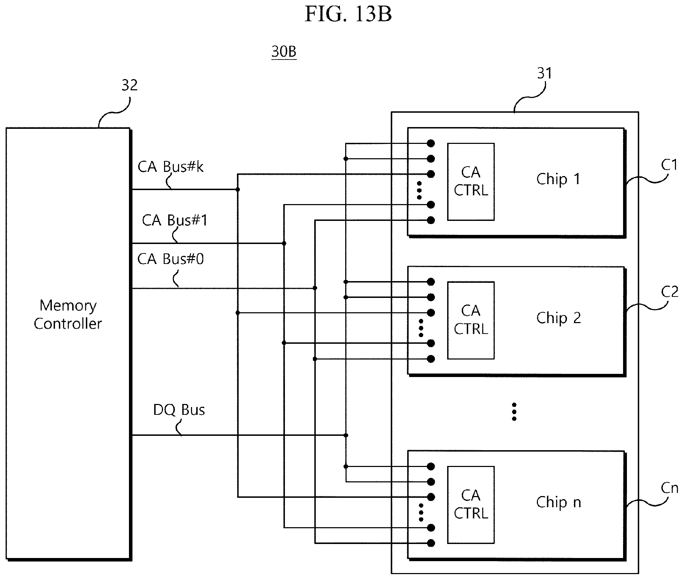

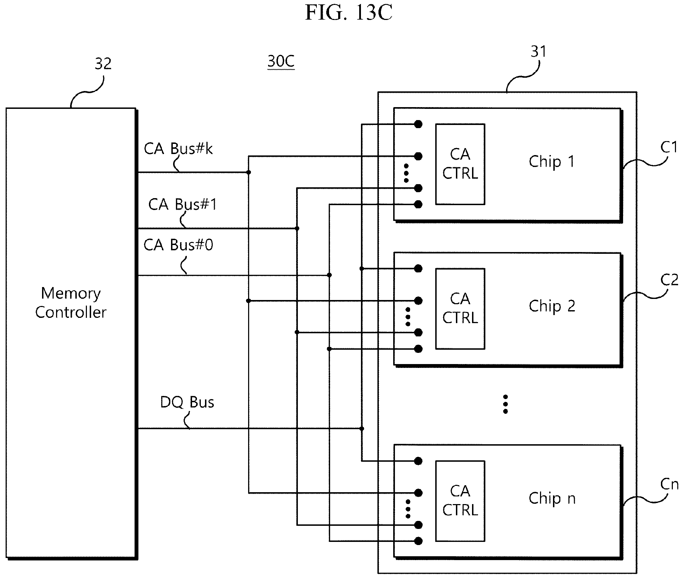

For example, as illustrated in FIGS. 13A and 13B, each of the chips may include two DQ pad sets. That is, the first chip C1 may include zeroth and first DQ pad sets, and the n-th chip Cn may also include zeroth and first DQ pad sets. According to some implementations, as shown in FIG. 13C, each of the chips may include one DQ pad set.

The DQ pad sets of each of the chips C1 to Cn may share the same DQ bus.

For example, as illustrated in FIG. 13A, the zeroth DQ pad sets of each of the chips C1 to Cn may be electrically connected to the zeroth DQ bus DQ Bus#0, and the first DQ pad sets of each of the chips C1 to Cn may be electrically connected to a first DQ bus DQ Bus#1. That is, a memory controller 32 and the nonvolatile memory device 31 may be electrically connected to each other through two DQ buses DQ Bus#0 and DQ Bus#1. According to some implementations, as illustrated in FIG. 13B, the zeroth and first DQ pad sets of each of the chips C1 to Cn may be electrically connected to a single DQ bus. That is, the memory controller 32 and the nonvolatile memory device 31 may be electrically connected to each other through one DQ bus. According to some implementations, as illustrated in FIG. 13C, the DQ pad set of each of the chips C1 to Cn may be electrically connected to a DQ bus.

The nonvolatile memory device 31 according to the present disclosure may receive commands in parallel from the memory controller 32 via the command-address buses CA Bus#0 to CA Bus#k. Accordingly, even when the data size is relatively small, the command-address overhead may be reduced, and the data input/output performance may be improved.

Furthermore, the nonvolatile memory device 31 according to the present disclosure may reconfigure a plane to which the CA pad set is assigned based on the data size. Accordingly, the data input/output performance may be further improved.

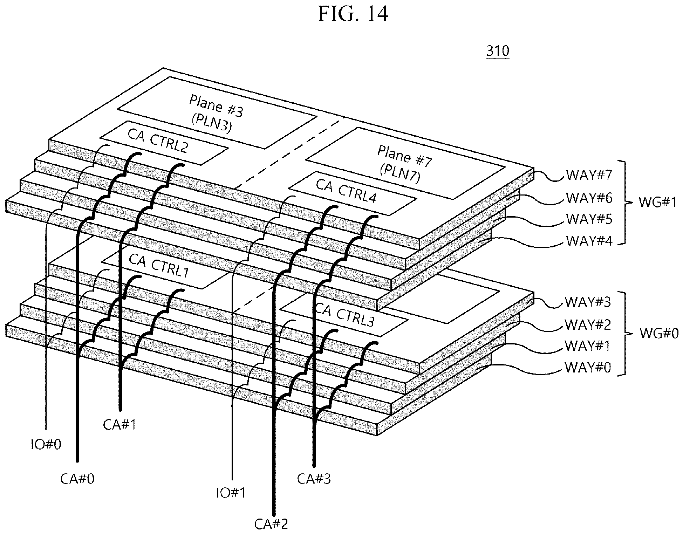

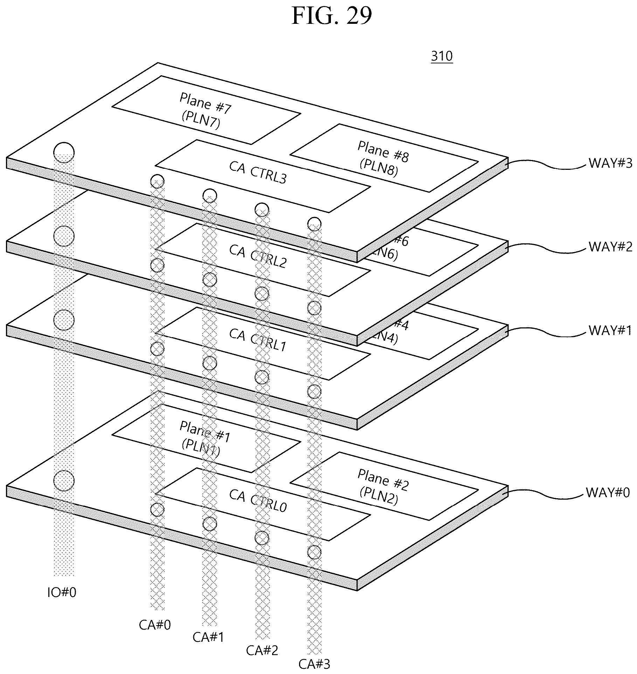

Hereinafter, implementations of assigning the CA pad set in the nonvolatile memory device generated by the pad wiring method will be described in more detail with reference to FIGS. 14 to 28. Furthermore, implementations of assigning the CA pad set in the nonvolatile memory device generated by the TSV method will be described in more detail with reference to FIGS. 29 to 35.

FIG. 14 is a view illustrating a nonvolatile memory device 310 formed by the pad wiring method according to some implementations of the present disclosure. The nonvolatile memory device 310 of FIG. 14 may correspond to the nonvolatile memory device of FIG. 13A. For convenience of explanation, it is assumed hereinafter that the nonvolatile memory device 310 includes eight ways, and each way includes two planes.

Referring to FIG. 14, the nonvolatile memory device 310 may include a plurality of ways WAY#0 to WAY#7 stacked in the vertical direction (e.g., the third direction (Z-axis direction)). In some implementations, one way may correspond to one chip of FIG. 13A. In this case, four lower ways WAY#0 to WAY#3 may form a zeroth way group WG#0, and four upper ways WAY#4 to WAY#7 may form a first way group WG#1.

Each of the ways WAY#0 to WAY#7 may include two planes.

For example, in the case of the zeroth way group WG#0, a zeroth plane may be arranged on the left side of a zeroth way WAY#0, and a fourth plane may be arranged on the right side. A first plane may be arranged on the left side of a first way WAY#1, and a fifth plane may be arranged on the right side. A second plane may be arranged on the left side of a second way WAY#2, and a sixth plane may be arranged on the right side. A third plane may be arranged on the left side of a third way WAY#3, and a seventh plane may be arranged on the right side.

In addition, for example, in the case of the first way group WG#1, a zeroth plane may be arranged on the left side of a fourth way WAY#4, and a fourth plane may be arranged on the right side. A first plane may be arranged on the left side of a fifth way WAY#5, and a fifth plane may be arranged on the right side. A second plane may be arranged on the left side of a sixth way WAY#6, and a sixth plane may be arranged on the right side. A third plane PLN3 may be arranged on the left side of a seventh way WAY#7, and a seventh plane PLN7 may be arranged on the right side.

Each of the ways WAY#0 to WAY#7 may include two CA control circuits.

For example, in the case of the zeroth way group WG#0, each of the zeroth to third ways WAY#0 to WAY#3 may include first and third CA control circuits CA CTRL1 and CA CTRL3. Further, for example, in the case of the first way group WG#1, each of the fourth to seventh ways WAY#4 to WAY#7 may include second and fourth CA control circuits CA CTRL2 and CA CTRL4.

The ways WAY#0 to WAY#7 may be electrically connected to each other by the pad wiring method.

For example, each of four command-address lines (hereinafter, referred to as 'CA lines') CA#0, CA#1, CA#2, and CA#3 may be electrically connected to the zeroth to seventh ways WAY#0 to WAY#7 by the pad wiring method. In addition, each of two input/output lines (hereinafter, referred to as 'IO lines') IO#0 and IO#1 may be electrically connected to the zeroth to seventh ways WAY#0 to WAY#7 by the pad wiring method.

Each of the four CA lines CA#0, CA#1, CA#2, and CA#3 may be electrically connected to one CA bus.

For example, a zeroth CA line CA#0 may be electrically connected to the zeroth CA bus CA Bus#0 (refer to FIG. 13A), and a first CA line CA#1 may be electrically connected to the first CA bus CA Bus#1 (refer to FIG. 13A). Similarly, second and third CA lines CA#2 and CA#3 may be electrically connected to the second and third CA buses, respectively.

In addition, each of the four CA lines CA#0, CA#1, CA#2, and CA#3 may be electrically connected to a CA pad set.

For example, the zeroth CA line CA#0 may be electrically connected to a zeroth CA pad set included in the ways WAY#0 to WAY#7. The first CA line CA#1 may be electrically connected to a first CA pad set included in the ways WAY#0 to WAY#7. Similarly, the second CA line CA#2 may be electrically connected to a second CA pad set included in the ways WAY#0 to WAY#7, and the third CA line CA#3 may be electrically connected to a third CA pad set included in the ways WAY#0 to WAY#7.

Each of the two IO lines IO#0 and IO#1 may be electrically connected to one DQ bus.

For example, a zeroth IO line IO#0 may be electrically connected to the zeroth DQ bus DQ Bus#0 (refer to FIG. 13A), and a first IO line IO#1 may be electrically connected to the first DQ bus DQ Bus#1 (refer to FIG. 13A).

In addition, each of two IO lines IO#0 and IO#1 may be electrically connected to the DQ pad set.

For example, the zeroth IO line IO#0 may be electrically connected to a zeroth DQ pad set included in the ways WAY#0 to WAY#7. The first IO line IO#1 may be electrically connected to a first DQ pad set included in the ways WAY#0 to WAY#7.

In some implementations of the present disclosure, the CA control circuit may correspond to one plane and may assign the CA line corresponding to the plane among the CA lines CA#0 to CA#3 to the plane.

For example, the seventh way WAY#7 may include the second CA control circuit CA CTRL2 and the fourth CA control circuit CA CTRL4. The second CA control circuit CA CTRL2 may correspond to the third plane PLN3 and may assign one of the CA lines CA#0 to CA#3 to the third plane PLN3. In addition, the fourth CA control circuit CA CTRL4 may correspond to the seventh plane PLN7 and may assign one of the CA lines CA#0 to CA#3 to the seventh plane PLN7.

In some implementations of the present disclosure, when the data size is relatively small, the nonvolatile memory device 310 may transmit and receive commands in parallel through the plural CA lines. Accordingly, the command overhead may be reduced, and the data transmission efficiency may be increased.

Further, in some implementations of the present disclosure, when the data size is relatively large, the nonvolatile memory device 310 may transmit and receive commands serially through one CA line. Accordingly, power consumption may be reduced while maintaining a high level of data transmission efficiency.

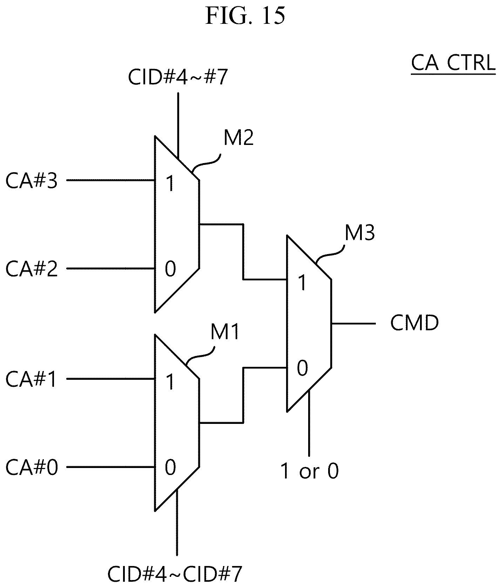

FIG. 15 is a view illustrating the CA control circuit of FIG. 14. The CA control circuit CA CTRL of FIG. 15 may correspond to one of the first to fourth CA control circuits CA CTRL1 to CA CTRL4 of FIG. 14.

Referring to FIG. 15, the CA control circuit CA CTRL may include a plurality of multiplexers M1, M2, and M3.

A first multiplexer M1 may be connected to the zeroth and first CA lines CA#0 and CA#1 and may select one of the zeroth and first CA lines CA#0 and CA#1 in response to a control signal. In this case, a chip ID CID may be provided as the control signal. For example, in a case where the chip ID CID is CID#4 to CID#7, the first multiplexer M1 may select the first CA line CA#1. In a case where the chip ID CID is not CID#4 to CID#7, the first multiplexer M1 may select the zeroth CA line CA#0. In some implementations, CID#4 to CID#7 may be the chip IDs CID of the fourth to seventh ways WAY#4 to WAY#7, respectively.

A second multiplexer M2 may be connected to the second and third CA lines CA#2 and CA#3 and may select one of the second and third CA lines CA#2 and CA#3 in response to a control signal. In this case, the chip ID CID may be provided as the control signal.

A third multiplexer M3 may be connected to an output of the first multiplexer M1 and an output of the second multiplexer M2 and may select either the output of the first multiplexer M1 or the output of the second multiplexer M2 in response to a control signal. In this case, '1' or '0' may be provided as the control signal. For example, when the control signal is '1', the output of the second multiplexer M2 may be selected. When the control signal is '0', the output of the first multiplexer M1 may be selected.

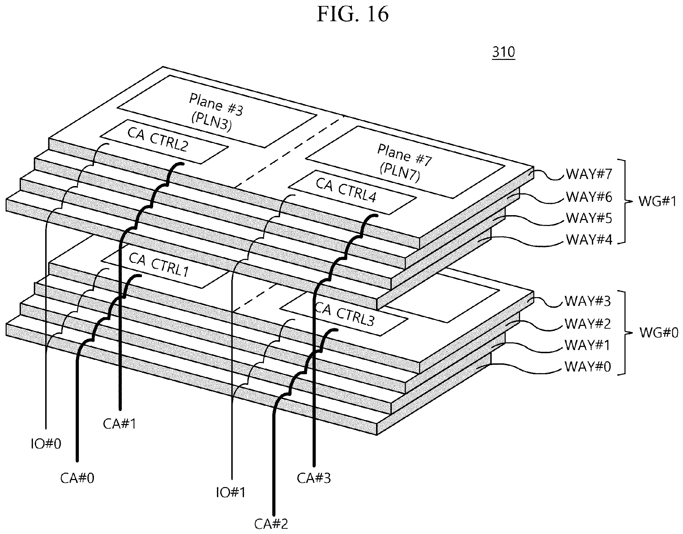

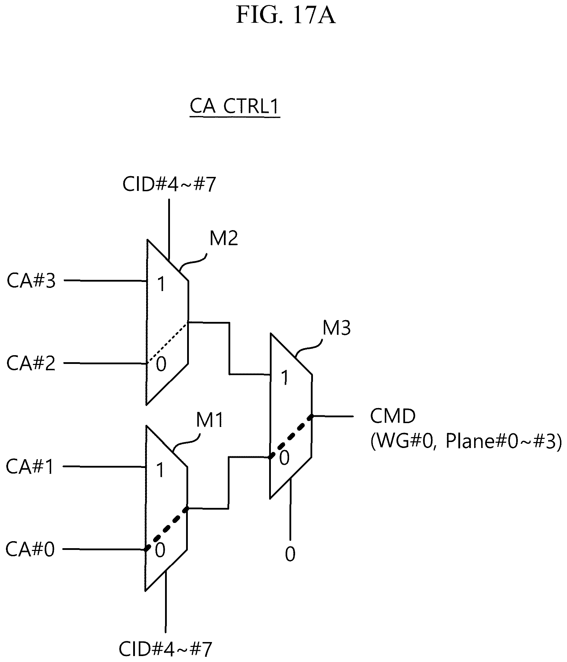

FIGS. 16 and 17A to 17D are views illustrating an operation of setting the non-volatile memory device 310 of FIG. 14 to enter the command-parallel mode using the CA control circuit of FIG. 15. In detail, FIG. 16 is a view illustrating an electrical connection state of the CA lines in the command-parallel mode according to some implementations of the present disclosure. FIGS. 17A to 17D are views illustrating the operation of the CA control circuit of FIG. 15 when entering the command-parallel mode of FIG. 16. In FIGS. 16 and 17A to 17D, a structure in which four CA lines CA#0, CA#1, CA#2, and CA#3 are allocated is illustrated as a representative example.

Referring to FIGS. 16 and 17A, the first CA control circuit CA CTRL1 may be disposed on the left side of each of the ways WAY#0 to WAY#3 of the zeroth way group WG#0.

Since the chip ID CID of the zeroth way group WG#0 is CID#0 to CID#3, the first multiplexer M1 selects the zeroth CA line CA#0, and the second multiplexer M2 selects the second CA line CA#2. Since the control signal of the third multiplexer M3 is '0', the third multiplexer M3 selects the first multiplexer M1.

As a result, the first CA control circuit CA CTRL1 assigns the zeroth CA line CA#0 to corresponding planes. That is, as illustrated in FIGS. 16 and 17A, the zeroth CA line CA#0 is assigned to the planes PLN0 to PLN3, which are disposed on the left side among the planes included in each of the ways WAY#0 to WAY#3 of the zeroth way group WG#0.

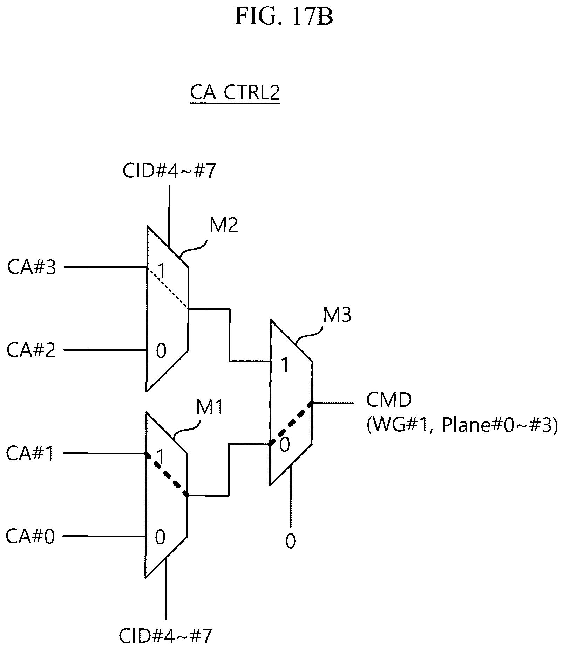

Referring to FIGS. 16 and 17B, the second CA control circuit CA CTRL2 may be disposed on the left side of each of the ways WAY#4 to WAY#7 of the first way group WG#1.

Since the chip ID CID of the first way group WG#1 is CID#4 to CID#7, the first multiplexer M1 selects the first CA line CA#1, and the second multiplexer M2 selects the third CA line CA#3. Since the control signal of the third multiplexer M3 is '0', the third multiplexer M3 selects the first multiplexer M1.

As a result, the second CA control circuit CA CTRL2 assigns the first CA line CA#1 to corresponding planes. That is, as illustrated in FIGS. 16 and 17B, the first CA line CA#1 is assigned to the planes PLN0 to PLN3, which are disposed on the left side among the planes included in each of the ways WAY#4 to WAY#7 of the first way group WG#1.

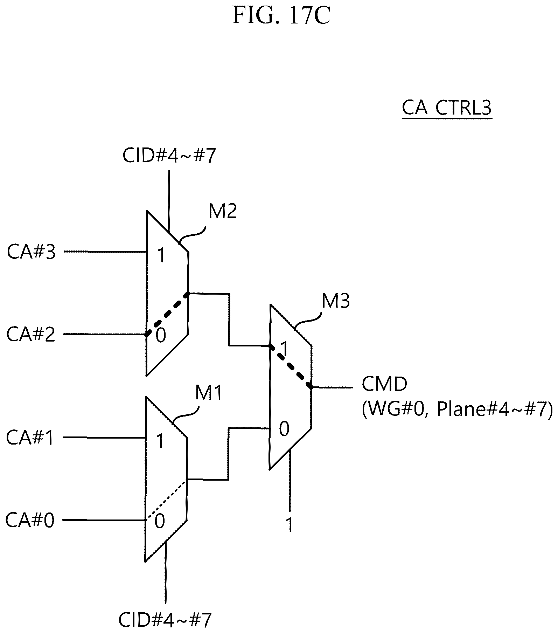

Referring to FIGS. 16 and 17C, the third CA control circuit CA CTRL3 is disposed on the right side of each of the ways WAY#0 to WAY#3 of the zeroth way group WG#0.

Since the chip ID CID of the zeroth way group WG#0 is CID#0 to CID#3, the first multiplexer M1 selects the zeroth CA line CA#0, and the second multiplexer M2 selects the second CA line CA#2. Since the control signal of the third multiplexer M3 is '1', the third multiplexer M3 selects the second multiplexer M2.

As a result, the third CA control circuit CA CTRL3 assigns the second CA line CA#2 to corresponding planes. That is, as illustrated in FIGS. 16 and 17C, the second CA line CA#2 is assigned to the planes PLN4 to PLN7, which are located on the right side among the planes included in each of the ways WAY#0 to WAY#3 of the zeroth way group WG#0.

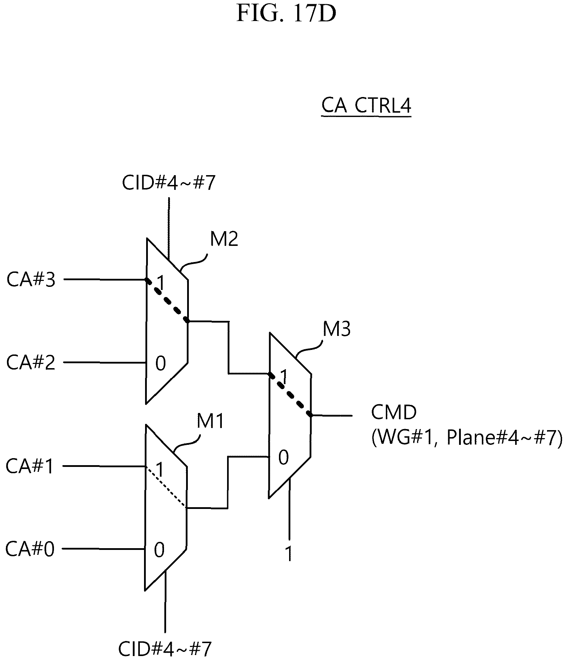

Referring to FIGS. 16 and 17D, the fourth CA control circuit CA CTRL4 is disposed on the right side of each of the ways WAY#4 to WAY#7 of the first way group WG#1.

Since the chip ID CID of the first way group WG#1 is CID#4 to CID#7, the first multiplexer M1 selects the first CA line CA#1, and the second multiplexer M2 selects the third CA line CA#3. Since the control signal of the third multiplexer M3 is '1', the third multiplexer M3 selects the second multiplexer M2.

As a result, the fourth CA control circuit CA CTRL4 assigns the third CA line CA#3 to corresponding planes. That is, as illustrated in FIGS. 16 and 17D, the third CA line CA#3 is assigned to the planes PLN4 to PLN7, which are disposed on the right side among the planes included in each of the ways WAY#4 to WAY#7 of the first way group WG#1.

As described above with reference to FIGS. 16 and 17A to 17D, the nonvolatile memory device 310 may receive the commands in parallel through the four CA lines, CA#0, CA#1, CA#2, and CA#3. Accordingly, even when the data size is small, the command overhead may be reduced.

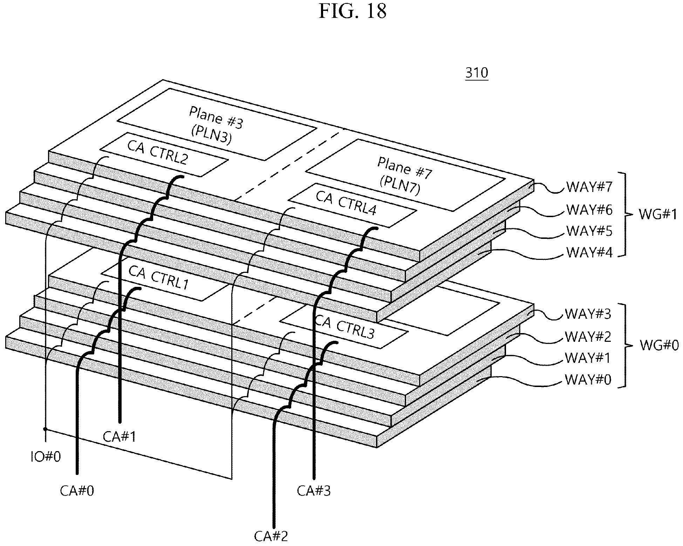

FIG. 18 is a view illustrating an electrical connection state of the CA lines in the command-parallel mode according to some implementations of the present disclosure. The nonvolatile memory device 310 of FIG. 18 is similar to the nonvolatile memory device 310 of FIG. 16. Therefore, redundant descriptions will be omitted.

In FIG. 16, two input/output lines IO#0 and IO#1 are shown as being electrically connected to different data buses DQ Bus#0 and DQ Bus#1 (refer to FIG. 13A), respectively. However, this is merely an example, and the present disclosure should not be limited thereto or thereby. For example, as illustrated in FIG. 18, two input/output lines IO#0 and IO#1 may be electrically connected to each other. In this case, the two input/output lines IO#0 and IO#1 may be electrically connected to the same data bus DQ Bus (refer to FIG. 13B).

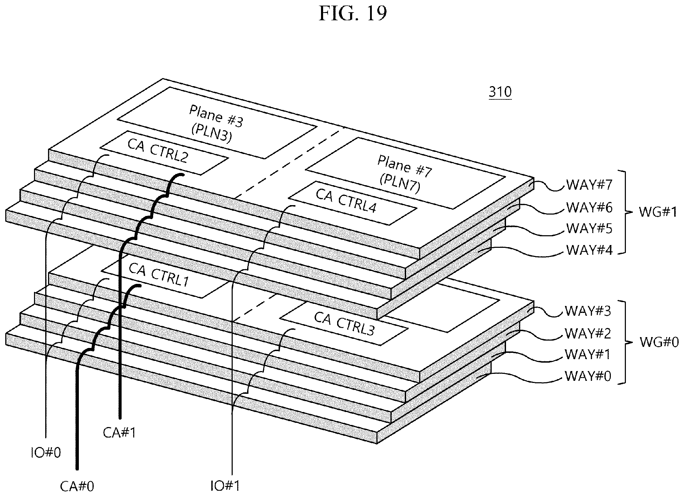

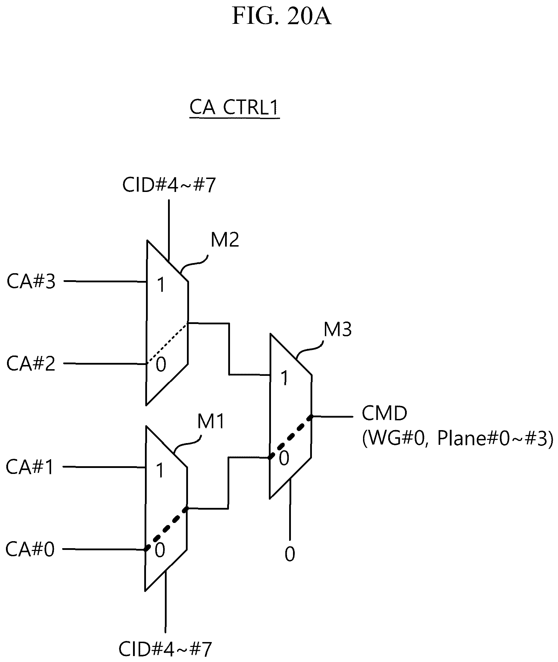

FIGS. 19 and 20A to 20D are views illustrating an operation of setting the non-volatile memory device 310 of FIG. 14 to enter the command-parallel mode using the CA control circuit of FIG. 15. In FIGS. 19 and 20A to 20D, a structure in which two CA lines CA#0 and CA#1 are allocated is illustrated as a representative example. FIGS. 19 and 20A to 20D are similar to FIGS. 16 and 17A to 17D. Therefore, redundant descriptions will be omitted.

Referring to FIGS. 19 and 20A, the first CA control circuit CA CTRL1 is disposed on the left side of each of the ways WAY#0 to WAY#3 of the zeroth way group WG#0. The first CA control circuit CA CTRL1 assigns the zeroth CA line CA#0 to corresponding planes. That is, the zeroth CA line CA#0 is assigned to the planes PLN0 to PLN3, which are disposed on the left side among the planes included in each of the ways WAY#0 to WAY#3 of the zeroth way group WG#0.

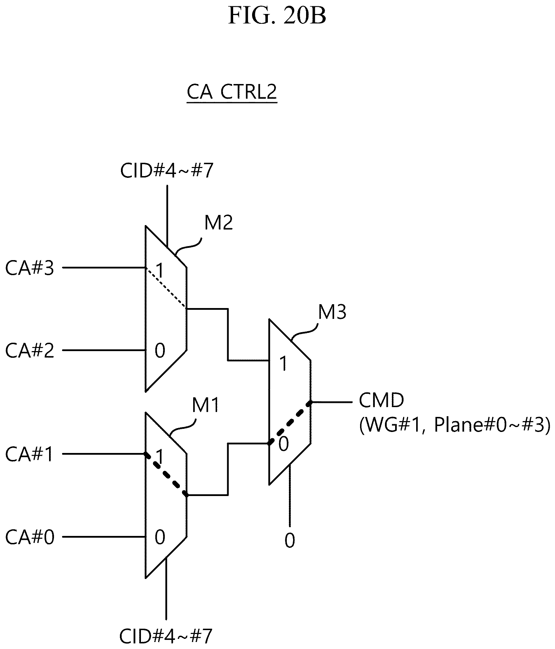

Referring to FIGS. 19 and 20B, the second CA control circuit CA CTRL2 is disposed on the left side of each of the ways WAY#4 to WAY#7 of the first way group WG#1. The second CA control circuit CA CTRL2 assigns the first CA line CA#1 to corresponding planes. That is, the first CA line CA#1 is assigned to the planes PLN0 to PLN3, which are disposed on the left side among the planes included in each of the ways WAY#4 to WAY#7 of the first way group WG#1.

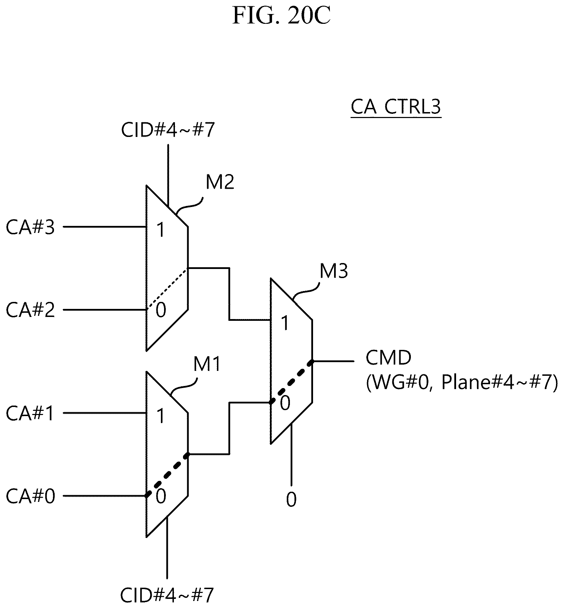

Referring to FIGS. 19 and 20C, the third CA control circuit CA CTRL3 is disposed on the right side of each of the ways WAY#0 to WAY#3 of the zeroth way group WG#0.

Since the chip ID CID of the zeroth way group WG#0 is CID#0 to CID#3, the first multiplexer M1 selects the zeroth CA line CA#0, and the second multiplexer M2 selects the second CA line CA#2. Since the control signal of the third multiplexer M3 is '0', the third multiplexer M3 selects the first multiplexer M1.

Therefore, the third CA control circuit CA CTRL3 assigns the zeroth CA line CA#0 to corresponding planes. That is, as illustrated in FIGS. 19 and 20C, the zeroth CA line CA#0 is assigned to the planes PLN4 to PLN7, which are disposed on the right side among the planes included in each of the ways WAY#0 to WAY#3 of the zeroth way group WG#0.

As a result, all planes of the ways WAY#0 to WAY#3 of the zeroth way group WG#0 receive commands through the zeroth CA line CA#0.

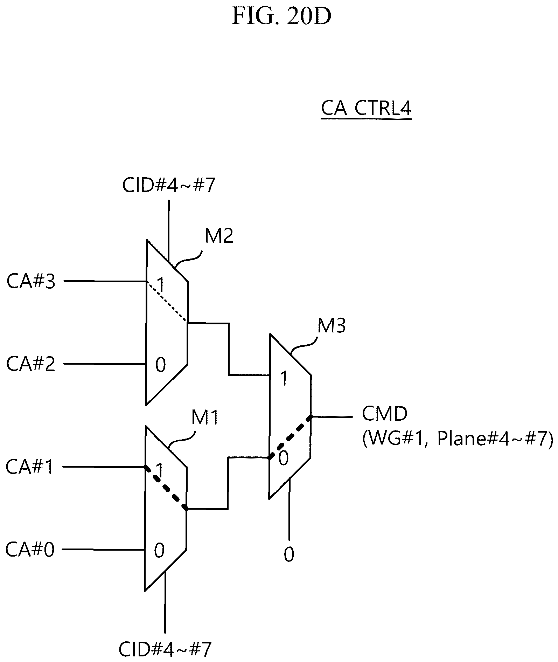

Referring to FIGS. 19 and 20D, the fourth CA control circuit CA CTRL4 is disposed on the right side of each of the ways WAY#4 to WAY#7 of the first way group WG#1.

Since the chip ID CID of the first way group WG#1 is CID#4 to CID#7, the first multiplexer M1 selects the first CA line CA#1, and the second multiplexer M2 selects the third CA line CA#3. Since the control signal of the third multiplexer M3 is '0', the third multiplexer M3 selects the first multiplexer M1.

Therefore, the fourth CA control circuit CA CTRL4 assigns the first CA line CA#1 to corresponding planes. That is, as illustrated in FIGS. 19 and 20D, the first CA line CA#1 is assigned to the planes PLN4 to PLN7, which are disposed on the right side among the planes included in each of the ways WAY#4 to WAY#7 of the first way group WG#1.

As a result, all planes of the ways WAY#4 to WAY#7 of the first way group WG#1 receive commands through the first CA line CA#1.

As described in FIGS. 19 and 20A to 20D, the nonvolatile memory device 310 may receive commands in parallel through two CA lines CA#0 and CA#1. Accordingly, when the data size is relatively small, the command overhead may be reduced, and the power consumption may also be appropriately adjusted.

In FIGS. 19 and 20A to 20D, the electrical connection of two unassigned CA lines CA#2 and CA#3 may be cut off, and thus, the two unassigned CA lines CA#2 and CA#3 may be in a floating state.

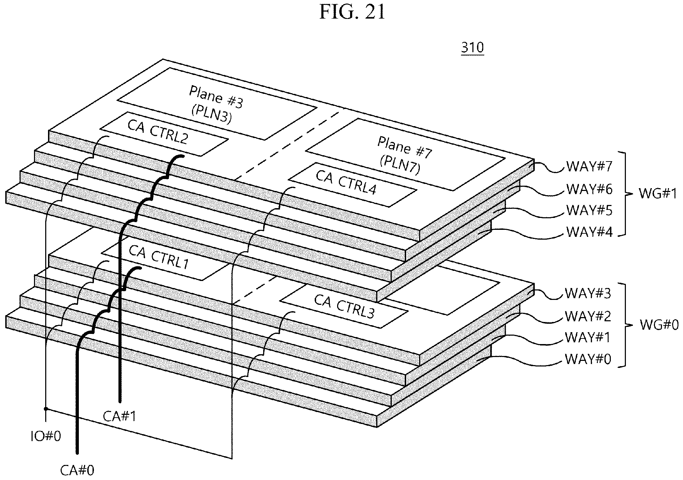

FIG. 21 is a view illustrating an electrical connection state of the CA lines in the command-parallel mode according to some implementations of the present disclosure. The nonvolatile memory device 310 of FIG. 21 is similar to the nonvolatile memory device 310 of FIG. 19. Therefore, redundant descriptions will be omitted.

In FIG. 19, two input/output lines IO#0 and IO#1 are illustrated as being electrically connected to different data buses DQ Bus#0 and DQ Bus#1 (refer to FIG. 13A), respectively. However, this is merely an example, and the present disclosure should not be limited thereto or thereby. For example, as illustrated in FIG. 21, two input/output lines IO#0 and IO#1 may be electrically connected to each other. In this case, the two input/output lines IO#0 and IO#1 may be electrically connected to the same data bus DQ Bus (refer to FIG. 13B).

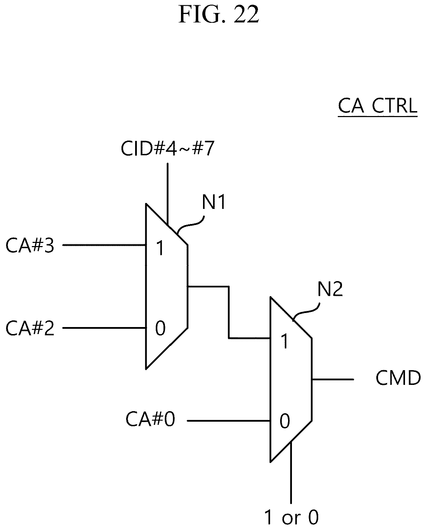

FIG. 22 is a view illustrating an example of the CA control circuit of FIG. 14. A CA control circuit CA CTRL of FIG. 22 may correspond to one of the first to fourth CA control circuits CA CTRL1 to CA CTRL4 of FIG. 14.

Referring to FIG. 22, the CA control circuit CA CTRL may include a plurality of multiplexers N1 and N2.

A first multiplexer N1 may be connected to second and third CA lines CA#2 and CA#3 and may select one of the second and third CA lines CA#2 and CA#3 in response to a control signal. In this case, a chip ID CID may be provided as the control signal. For example, in a case where the chip ID CID is CID#4 to CID#7, the first multiplexer N1 may select the third CA line CA#3. In a case where the chip ID CID is not CID#4 to CID#7, the first multiplexer N1 may select the second CA line CA#2. In some implementations, CID#4 to CID#7 may be the chip IDs CID of fourth to seventh ways WAY#4 to WAY#7, respectively.

A second multiplexer N2 may be connected to a zeroth CA line CA#0 and the first multiplexer N1 and may select one of the zeroth CA line CA#0 and the first multiplexer N1 in response to a control signal. In this case, '1' or '0' may be provided as the control signal. For example, when the control signal is '1', an output of the first multiplexer N1 may be selected. When the control signal is '0', the zeroth CA line CA#0 may be selected.

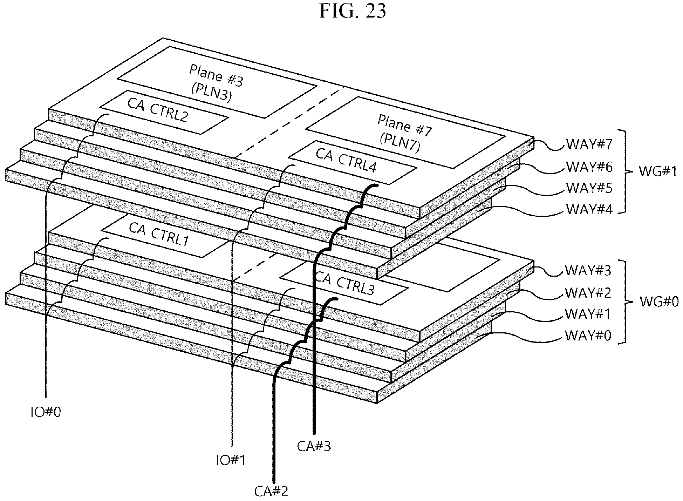

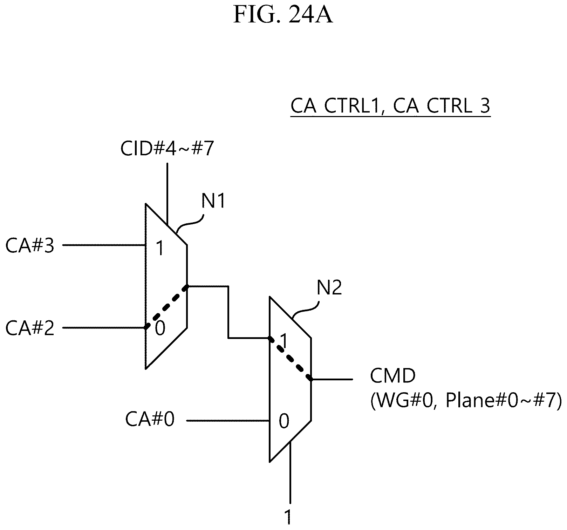

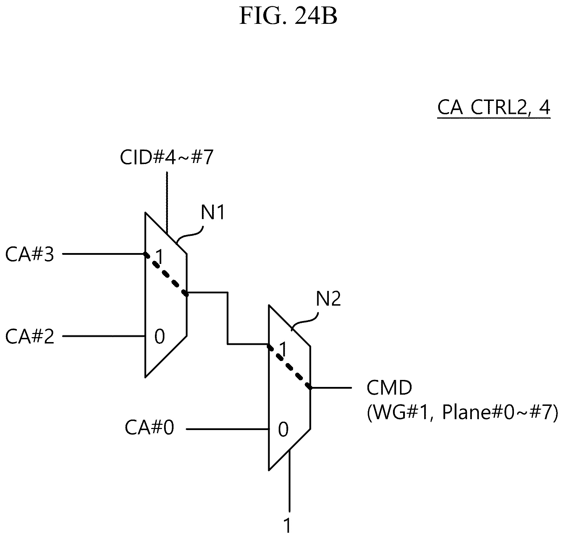

FIGS. 23, 24A, and 24B are views illustrating an operation of setting the non-volatile memory device of FIG. 14 to enter the command-parallel mode using the CA control circuit of FIG. 22. In detail, FIG. 23 is a diagram illustrating an electrical connection state of the CA lines in the command-parallel mode according some implementations of to the present disclosure. FIGS. 24A and 24B are views illustrating the operation of the CA control circuit of FIG. 22 when entering the command-parallel mode of FIG. 23. In FIGS. 23, 24A, and 24B, a structure in which two CA lines CA#2 and CA#3 are allocated is illustrated.

Referring to FIGS. 23 and 24A, the first and third CA control circuits CA CTRL1 and CA CTRL3 are disposed in each of the ways WAY#0 to WAY#3 of the zeroth way group WG#0.

Since the chip ID CID of the zeroth way group WG#0 is CID#0 to CID#3, the first multiplexer N1 selects the second CA line CA#2. Since the control signal of the second multiplexer N2 is '1', the second multiplexer N2 selects the first multiplexer N1.

As a result, both the first and third CA control circuits CA CTRL1 and CA CTRL3 assign the second CA line CA#2 to corresponding planes. That is, as illustrated in FIGS. 23 and 24A, the second CA line CA#2 is assigned to all planes included in each of the ways WAY#0 to WAY#3 of the zeroth way group WG#0.

Referring to FIGS. 23 and 24B, the second and fourth CA control circuits CA CTRL2 and CA CTRL4 are disposed in each of the ways WAY#4 to WAY#7 of the first way group WG#1.

Since the chip ID CID of the first way group WG#1 is CID#4 to CID#7, the first multiplexer N1 selects the third CA line CA#3. Since the control signal of the second multiplexer N2 is '1', the second multiplexer N2 selects the first multiplexer N1.

As a result, both the second and fourth CA control circuits CA CTRL2 and CA CTRL4 assign the third CA line CA#3 to corresponding planes. That is, as illustrated in FIGS. 23 and 24B, the third CA line CA#3 is assigned to all planes included in each of the ways WAY#4 to WAY#7 of the first way group WG#1.

As described with reference to FIGS. 23, 24A, and 24B, the nonvolatile memory device 310 may receive commands in parallel through two CA lines, CA#2 and CA#3. Accordingly, when the data size is relatively small, the command overhead be reduced, and the power consumption may also be appropriately adjusted.

In FIGS. 23, 24A, and 24B, the electrical connection of two unassigned CA lines CA#0 and CA#1 may be cut off, and thus, the two unassigned CA lines CA#0 and CA#1 may be in a floating state.

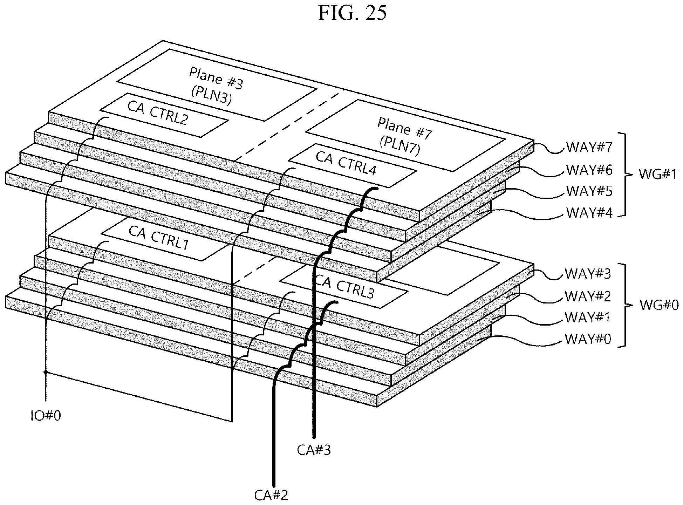

FIG. 25 is a view illustrating an electrical connection state of the CA lines in the command-parallel mode according to some implementations of the present disclosure. The nonvolatile memory device 310 of FIG. 25 is similar to the nonvolatile memory device 310 of FIG. 23. Therefore, redundant descriptions will be omitted.

In FIG. 23, two input/output lines IO#0 and IO#1 are shown as being electrically connected to different data buses DQ Bus#0 and DQ Bus#1 (refer to FIG. 13A), respectively. However, this is merely an example, and the present disclosure should not be limited thereto or thereby. For example, as illustrated in FIG. 25, two input/output lines IO#0 and IO#1 may be electrically connected to each other. In this case, the two input/output lines IO#0 and IO#1 may be electrically connected to the same data bus DQ Bus (refer to FIG. 13B).

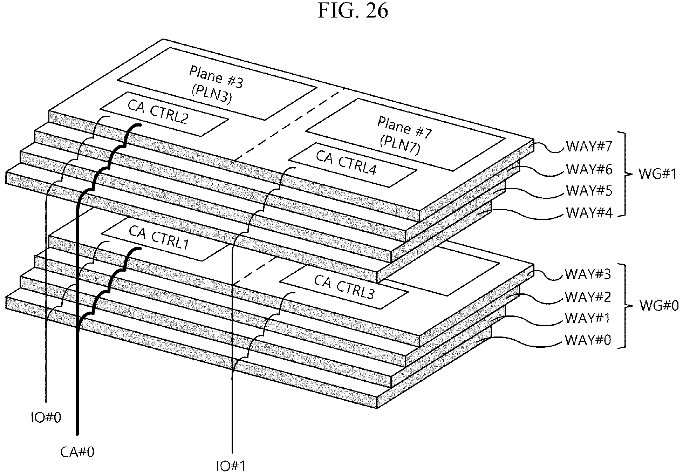

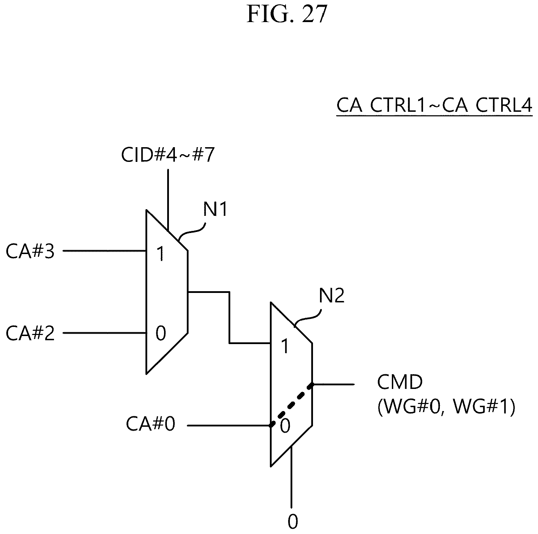

FIGS. 26 and 27 are views illustrating an operation of setting the non-volatile memory device of FIG. 14 to enter the command-serial mode using the CA control circuit of FIG. 22. Specifically, FIG. 26 is a view illustrating an electrical connection state of the CA lines in the command-serial mode according to the present disclosure. FIG. 27 is a view illustrating the operation of the CA control circuit of FIG. 22 when entering the command-serial mode. In FIGS. 26 and 27, a structure in which one CA line CA#0 is allocated is illustrated.

Referring to FIGS. 26 and 27, since the control signal of the second multiplexer N2 is '0', the second multiplexer N2 selects the zeroth CA line CA#0. Accordingly, all the first to fourth CA control circuits CA CTRL1 to CA CTRL4 assign the zeroth CA line CA#0 to corresponding planes. That is, as illustrated in FIGS. 26 and 27, the zeroth CA line CA#0 is assigned to all planes included in each of the zeroth way group WG#0 and the first way group WG#1.

Therefore, when the data size is large and the command-address overhead is not an issue, the command-serial mode may be performed to save power while maintaining the data input/output performance.

In FIGS. 26 and 27, the electrical connection of three unassigned CA lines CA#1, CA#2, and CA#3 may be cut off, and thus, the three unassigned CA lines CA#1, CA#2, and CA#3 may be in a floating state.

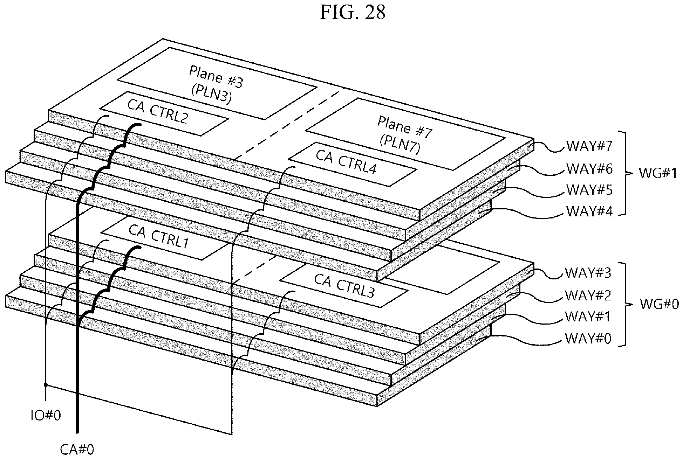

FIG. 28 is a view illustrating an electrical connection state of the CA lines in the command-serial mode according to some implementations of the present disclosure. The nonvolatile memory device 310 of FIG. 28 is similar to the nonvolatile memory device 310 of FIG. 26. Therefore, redundant descriptions will be omitted.

In FIG. 26, two input/output lines IO#0 and IO#1 are shown as being electrically connected to different data buses DQ Bus#0 and DQ Bus#1 (refer to FIG. 13A), respectively. However, this is merely an example, and the present disclosure should not be limited thereto or thereby. For example, as illustrated in FIG. 28, two input/output lines IO#0 and IO#1 may be electrically connected to each other. In this case, the two input/output lines IO#0 and IO#1 may be electrically connected to the same data bus DQ Bus (refer to FIG. 13B).

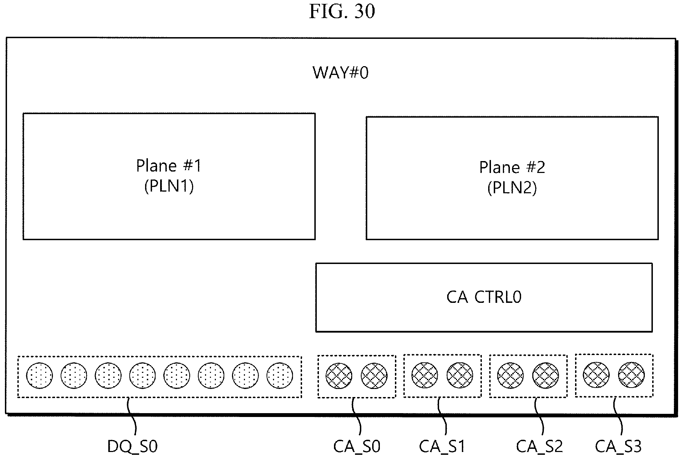

FIG. 29 is a view illustrating a nonvolatile memory device 310 formed by the TSV method according to some implementations of the present disclosure. FIG. 30 is a view illustrating one of ways of the nonvolatile memory device 310. The nonvolatile memory device 310 of FIG. 29 may correspond to the nonvolatile memory device of FIG. 13C. For convenience of explanation, it is assumed that the nonvolatile memory device 310 includes four ways and each way includes two planes.

Referring to FIG. 29, the nonvolatile memory device 310 may include a plurality of ways WAY#0 to WAY#3 stacked in the vertical direction (e.g., the third direction (Z-axis direction)). In some implementations, one way may correspond to one chip of FIG. 13C.

Each of the ways WAY#0 to WAY#3 may include two planes.

For example, first and second planes PLN1 and PLN2 may be arranged in a zeroth way WAY#0. Third and fourth planes may be arranged in a first way WAY#1. Fifth and sixth planes may be arranged in a second way WAY#2. Seventh and eighth planes PLN7 and PLN8 may be arranged in a third way WAY#3.

Each of the ways WAY#0 to WAY#4 may include a CA control circuit.

For example, a zeroth CA control circuit CA CTRL0 may be arranged in the zeroth way WAY#0. A first CA control circuit CA CTRL1 may be arranged in the first way WAY#1. Similarly, second and third CA control circuits CA CTRL2 and CA CTRL3 may be arranged in the second and third ways WAY#2 and WAY#3, respectively.

The ways WAY#0 to WAY#3 may be electrically connected to each other by the TSV method.

For example, four CA lines CA#0, CA#1, CA#2, and CA#3 may be electrically connected to the zeroth to third ways WAY#0 to WAY#3, respectively, by the TSV method. In addition, for example, one IO line IO#0 may be electrically connected to the zeroth to third ways WAY#0 to WAY#3 by the TSV method.

Each of the four CA lines CA#0, CA#1, CA#2, and CA#3 may be electrically connected to one CA bus.

For example, a zeroth CA line CA#0 may be electrically connected to the zeroth CA bus CA Bus#0 (refer to FIG. 13C), and a first CA line CA#1 may be electrically connected to the first CA bus CA Bus#1 (refer to FIG. 13C). Similarly, second and third CA lines CA#2 and CA#3 may be electrically connected to the second and third CA buses, respectively.

Each of the four CA lines CA#0, CA#1, CA#2, and CA#3 may be electrically connected to a CA pad set.

For example, as illustrated in FIG. 30, each way may include four CA pad sets, CA_S0, CA_S1, CA_S2, and CA_S3 and one DQ pad set DQ_S0. In this case, the zeroth CA line CA#0 may be electrically connected to a zeroth CA pad set CA_S0 included in the ways WAY#0 to WAY#3. The first CA line CA#1 may be electrically connected to a first CA pad set CA_S1 included in the ways WAY#0 to WAY#3. Similarly, the second and third CA lines CA#2 and CA#3 may be electrically connected to second and third CA pad sets CA_S2 and CA_S3, respectively.

The IO line IO#0 may be electrically connected to a DQ bus. As an example, a zeroth IO line IO#0 may be electrically connected to the DQ bus (refer to FIG. 13A).

In addition, the IO line IO#0 may be electrically connected to the DQ pad set. As an example, the zeroth IO line IO#0 may be electrically connected to a zeroth DQ pad set DQ_S0 included in the ways WAY#0 to WAY#3.

In some implementations of the present disclosure, the CA control circuit may correspond to two planes and may assign the CA line corresponding to the planes among the CA lines CA#0 to CA#3.

For example, the zeroth way WAY#0 may include the zeroth CA control circuit CA CTRL0. The zeroth CA control circuit CA CTRL0 may correspond to the first and second planes PLN1 and PLN2. In addition, the zeroth CA control circuit CA CTRL0 may assign one of the CA lines CA#0 to CA#3 to the first and second planes PLN1 and PLN2.

In some implementations of the present disclosure, when the data size is relatively small, the nonvolatile memory device 310 may transmit and receive commands in parallel through the CA lines. Accordingly, the command overhead may be reduced, and the data transmission efficiency may increase.

In some implementations of the present disclosure, when the data size is relatively large, the nonvolatile memory device 310 may transmit and receive commands serially through one CA line. Accordingly, power consumption may be reduced while maintaining a high level of data transmission efficiency.

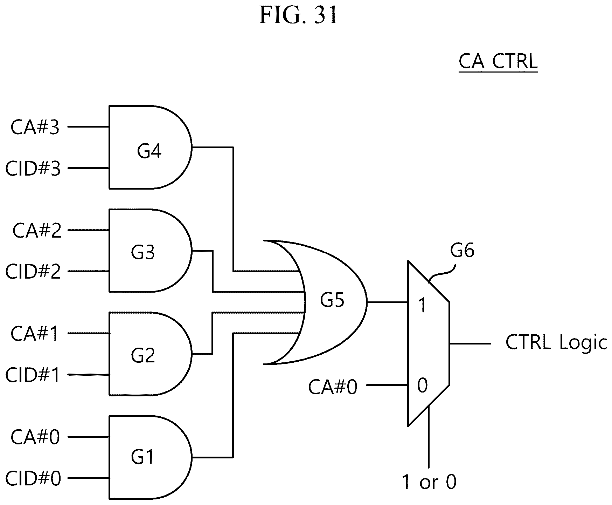

FIG. 31 is a view illustrating the CA control circuit of FIG. 29. The CA control circuit CA CTRL of FIG. 31 may correspond to one of the zeroth to third CA control circuits CA CTRL0 to CA CTRL3 of FIG. 29.

Referring to FIG. 31, the CA control circuit CA CTRL may include a plurality of logic gates G1 to G5 and a multiplexer G6.

First to fourth logic gates G1 to G4 may be NAND gates. The first logic gate G1 may receive a signal of the zeroth CA line CA#0 and a zeroth chip ID CID#0 as inputs. A second logic gate G2 may receive a signal of the first CA line CA#1 and a first chip ID CID#1 as inputs. Similarly, a third logic gate G3 may receive a signal of the second CA line CA#2 and a second chip ID CID#2 as inputs, and the fourth logic gate G4 may receive a signal of the third CA line CA#3 and a third chip ID CID#3 as inputs.

A fifth logic gate G5 may be an OR gate. The fifth logic gate G5 may receive output signals of the first to fourth logic gates G1 to G4 as inputs.

The multiplexer G6 may be connected to the zeroth CA line CA#0 and an output of the fifth logic gate G5 and may select either the zeroth CA line CA#0 or the output of the fifth logic gate G5 in response to a control signal. In this case, '1' or '0' may be provided as the control signal. For example, when the control signal is '1', the output of the fifth logic gate G5 may be selected. When the control signal is '0', the zeroth CA line CA#0 may be selected.

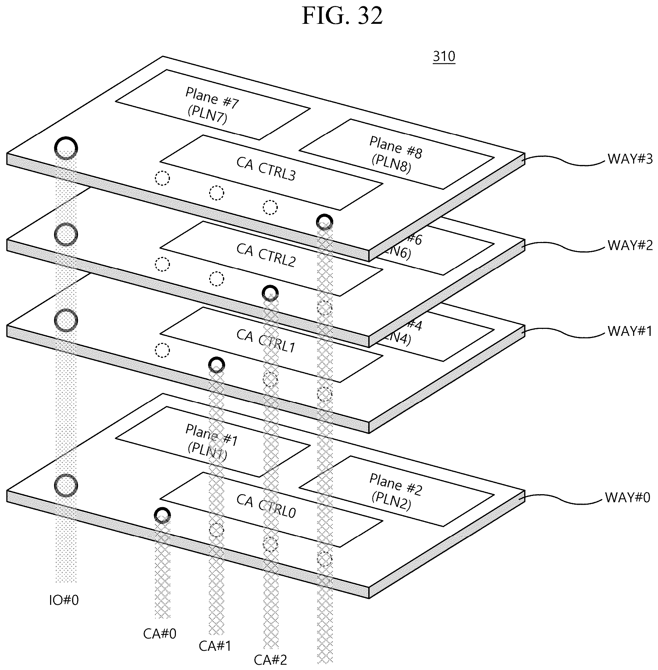

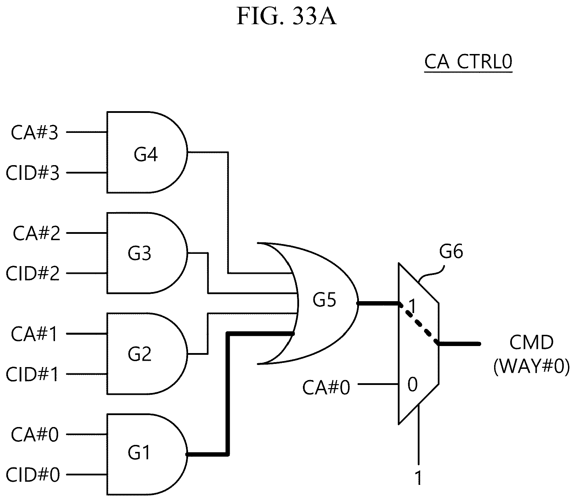

FIGS. 32 to 33A to 33D are views illustrating an operation of setting the non-volatile memory device of FIG. 29 to enter the command-parallel mode using the CA control circuit of FIG. 31. Specifically, FIG. 32 is a view illustrating an electrical connection state of the CA lines in the command-parallel mode according to some implementations of the present disclosure. FIGS. 33A to 33D are views illustrating the operation of the CA control circuit of FIG. 31 when entering the command-parallel mode of FIG. 32. In FIGS. 32 and 33A to 33D, a structure in which four CA lines CA#0, CA#1, CA#2, and CA#3 are allocated is illustrated.

Referring to FIGS. 32 and FIG. 33A, the zeroth CA control circuit CA CTRL0 may determine a CA line to be assigned to the zeroth way WAY#0.

In detail, since the chip ID CID of the zeroth way WAY#0 is CID#0, an input signal corresponding to the chip ID CID among input signals of the first logic gate G1 may be always activated to a high state. An input signal corresponding to the chip ID CID among input signals of the second to fourth logic gates G2 to G4 may be always deactivated to a low state.

Then, when a command is received through the zeroth CA line CA#0, another input signal among the input signals of the first logic gate G1 may be activated high. Accordingly, the command received on the zeroth CA line CA#0 may be transmitted to the multiplexer G6 through the first logic gate G1 and the fifth logic gate G5. Further, since the control signal of the multiplexer G6 is '1', the multiplexer G6 may select the fifth logic gate G5.

Consequently, the zeroth CA control circuit CA CTRL0 may allocate the zeroth CA line CA#0 to the zeroth way WAY#0.

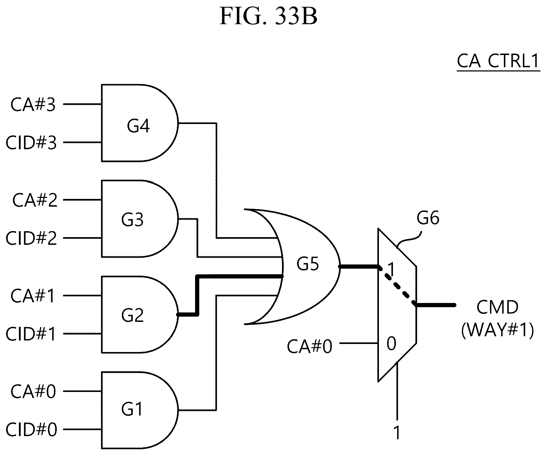

Similarly, referring to FIGS. 32 and 33B, the first CA control circuit CA CTRL1 may determine the CA line to be assigned to the first way WAY#1.

In detail, since the chip ID CID of the first way WAY#1 is CID#1, the input signal corresponding to the chip ID CID among the input signals of the second logic gate G2 may be always activated high. Then, when a command is received through the first CA line CA#1, the command received on the first CA line CA#1 may be transmitted to the multiplexer G6 through the second logic gate G2 and the fifth logic gate G5. Since the control signal of the multiplexer G6 is '1', the multiplexer G6 may select the fifth logic gate G5.

Consequently, the first CA control circuit CA CTRL1 may assign the first CA line CA#1 to the first way WAY#1.

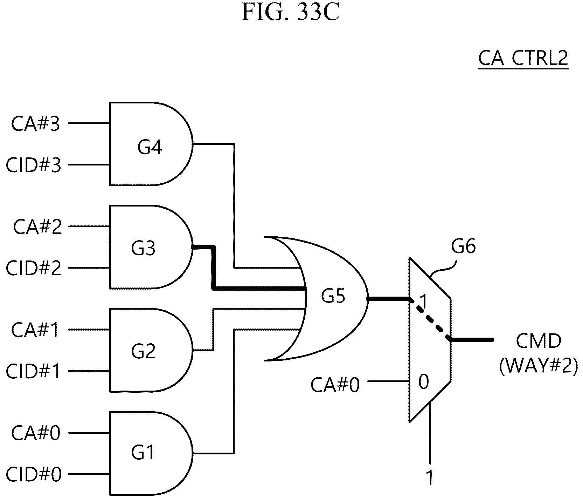

Similarly, referring to FIGS. 32 and 33C, the second CA control circuit CA CTRL2 may determine a CA line to be assigned to the second way WAY#2. For example, the second CA control circuit CA CTRL2 may allocate the second CA line CA#2 to the second way WAY#2.

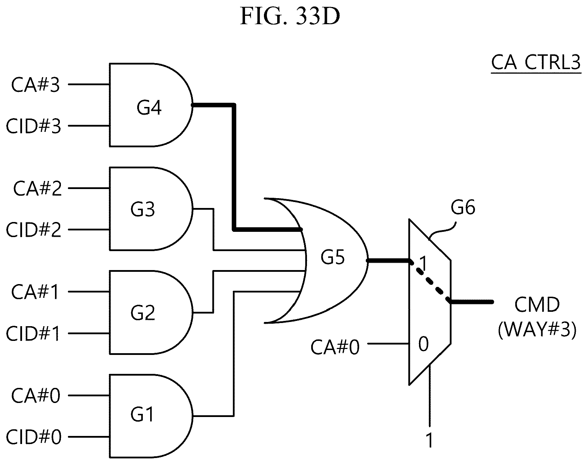

Similarly, referring to FIGS. 32 and 33D, the third CA control circuit CA CTRL3 may determine a CA line to be assigned to the third way WAY#3. For example, the third CA control circuit CA CTRL3 may allocate the third CA line CA#3 to the third way WAY#3.

As described above with reference to FIGS. 32 and 33A to 33D, the nonvolatile memory device 310 may receive the commands in parallel through the four CA lines CA#0, CA#1, CA#2, and CA#3. Accordingly, even when the data size is small, the command overhead may be reduced.

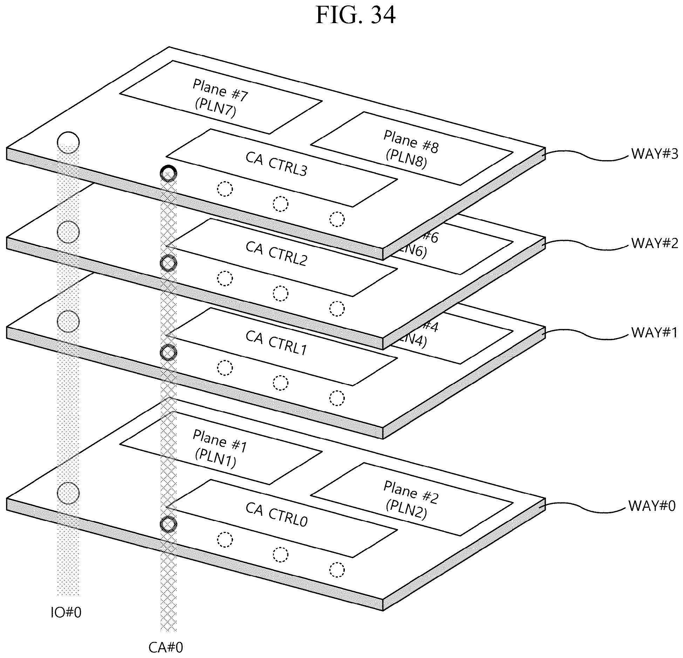

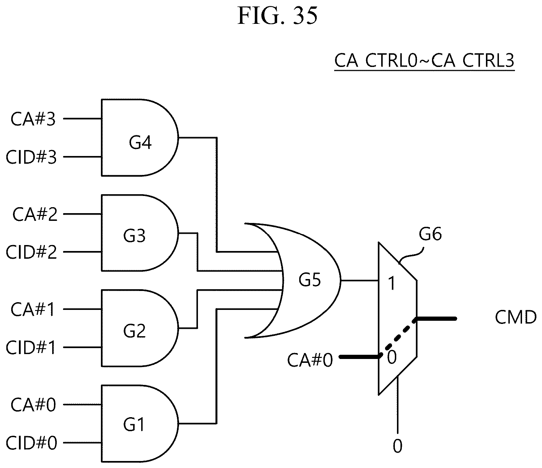

FIGS. 34 and 35 are views illustrating an operation of setting the non-volatile memory device 310 of FIG. 29 to enter the command-serial mode using the CA control circuit of FIG. 31. In detail, FIG. 34 is a view illustrating an electrical connection state of the CA lines in the command-serial mode according to some implementations of the present disclosure. FIG. 35 is a view illustrating the operation of the CA control circuit of FIG. 31 when entering the command-serial mode. FIGS. 34 and 35 illustrate a structure in which one CA line CA#0 is allocated as a representative example.

Referring to FIGS. 34 and FIG. 35, since the control signal of the multiplexer G6 is '0', the multiplexer G6 may select the zeroth CA line CA#0. Therefore, all the zeroth to third CA control circuits CA CTRL0 to CA CTRL3 may allocate the zeroth CA line CA#0 to their corresponding ways. That is, as illustrated in FIGS. 34 and 35, the zeroth CA line CA#0 may be allocated to all the ways WAY#0 to WAY#3. Accordingly, in a case where the data size is large and the command-address overhead is not an issue, the command-serial mode may be executed, which reduces power consumption while maintaining data input/output performance.

In FIGS. 34 and 35, the electrical connection of three unassigned CA lines CA#1, CA#2, and CA#3 may be cut off, and thus, the three unassigned CA lines CA#1, CA#2, and CA#3 may be in a floating state.

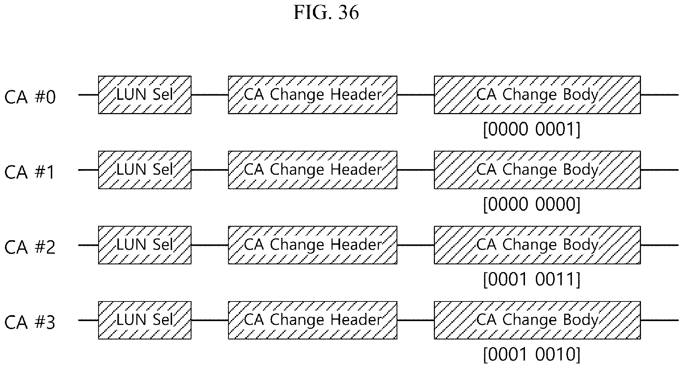

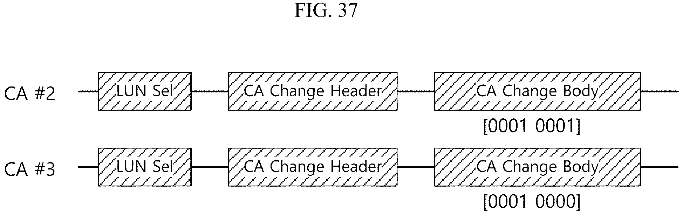

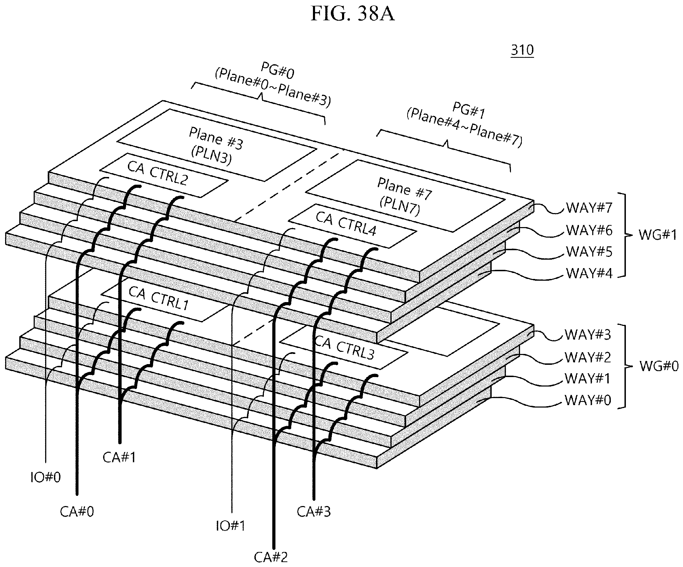

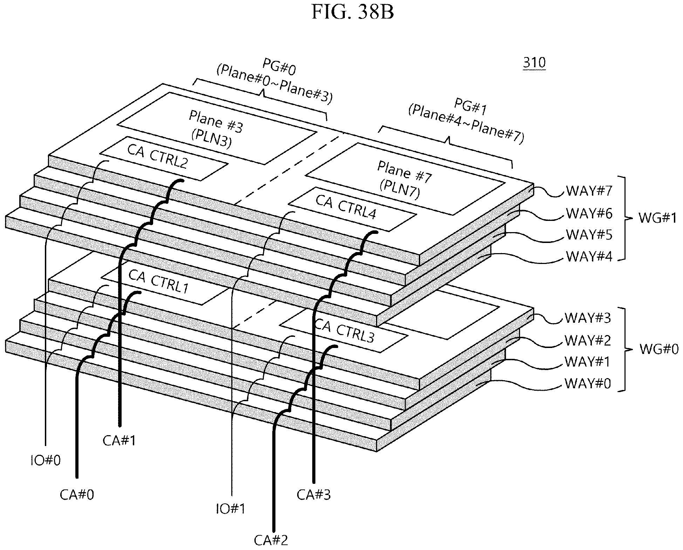

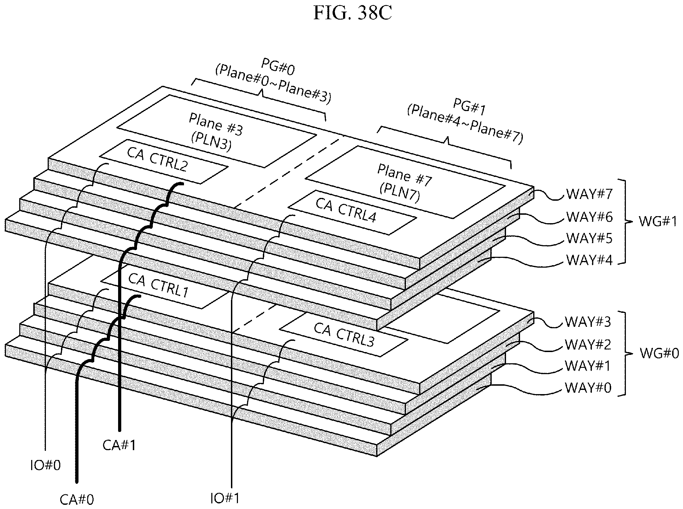

FIGS. 36, 37, and 38A to 38C are views illustrating an operation in which a command requesting a reallocation of a CA pad set is received and an allocation of the CA pad set is changed in response to the request. In detail, FIG. 36 illustrates a command that requests the allocation of four CA lines CA#0, CA#1, CA#2, and CA#3. FIG. 37 illustrates a command that requests the allocation of two CA lines CA#0 and CA#1. FIG. 38A illustrates the nonvolatile memory device 310 in an initial state. FIG. 38B illustrates the nonvolatile memory device 310 in which the electrical connection state is changed in response to the command of FIG. 36. FIG. 38C illustrates the nonvolatile memory device 310 in which the electrical connection state is changed in response to the command of FIG. 37. The nonvolatile memory device 310 of FIGS. 38A to 38C is similar to those of FIGS. 14 to 28. Accordingly, redundant descriptions will be omitted.

First, an example of reallocating the CA line from the state in FIG. 38A to that in FIG. 38B will be described.

Referring to FIGS. 36, 38A, and 38B, a LUN selection packet LUNSel may be received through the zeroth CA line CA#0. The LUN selection packet LUNSel may indicate the fourth way WAY#4.

Then, a CA change header may be received through the zeroth CA line CA#0. The CA change header may include information indicating that the CA line previously allocated to the fourth way WAY#4 is changed.

Then, a CA change body may be received through the zeroth CA line CA#0. For example, the CA change body may include 8 bits where the first 4 bits may indicate a target plane and the last 4 bits may indicate the CA line to which the target plane will be reallocated. For instance, the first 4 bits '0000' may indicate the zeroth plane PLN0, which is the target plane, and the last 4 bits '0001' may indicate the first CA line CA#1 to which the target plane will be reallocated.

Accordingly, the nonvolatile memory device 310 may reallocate the zeroth plane PLN0 of the fourth way WAY#4 to the first CA line CA#1.

These commands may be repeatedly received for the first to third planes PLN1 to PLN3 of the fifth to seventh ways WAY#5 to WAY#7. Consequently, as illustrated in FIG. 38B, the nonvolatile memory device 310 may reallocate the planes belonging to the first way group WG#1 and a zeroth plane group PG#0 to the first CA line CA#1.

Similarly, the LUN selection packet LUNSel may be received through the first CA line CA#1. The LUN selection packet LUNSel may indicate the zeroth way WAY#0.

Then, the CA change header may be received through the first CA line CA#1.

Then, the CA change body may be received through the first CA line CA#1. For example, the CA change body may include 8 bits where the first 4 bits'0000' may indicate the zeroth plane PLN0, which is the target plane, and the last 4 bits '0000' may indicate the zeroth CA line CA#0 to which the target plane will be reallocated. Accordingly, the nonvolatile memory device 310 may reallocate the zeroth plane PLN0 of the zeroth way WAY#0 to the zeroth CA line CA#0.

These commands may be received repeatedly for the first to third planes PLN1 to PLN3 of the first to third ways WAY#1 to WAY#3. Consequently, as illustrated in FIG. 38B, the nonvolatile memory device 310 may reallocate planes belonging to the zeroth way group WG#0 and the zeroth plane group PG#0 to the zeroth CA line CA#0.

In this manner, the planes belonging to the zeroth way group WG#0 and a first plane group PG#1 may be reallocated to the second CA line CA#2. Further, the planes belonging to the first way group WG#0 and the first plane group PG#1 may be reallocated to the third CA line CA#3.

Subsequently, an example in which the CA line is reassigned from FIG. 38B to FIG. 38C will be described.

Referring to FIGS. 36, 38B, and 38C, the LUN selection packet LUNSel may be received through the second CA line CA#2. The LUN selection packet LUNSel may indicate the zeroth way WAY#0.

Then, the CA change header may be received through the second CA line CA#2.

Subsequently, the CA change body may be received through the second CA line CA#2. For example, the CA change body may include 8 bits where the first 4 bits '0001' may indicate the fourth plane PLN4, which is the target plane, and the last 4 bits '0011' may indicate the zeroth CA line CA#0 to which the target plane will be reallocated.

Accordingly, the nonvolatile memory device 310 may reallocate the fourth plane PLN4 of the zeroth way WAY#0 from the second CA line CA#2 to the zeroth CA line CA#0.

These commands may be received repeatedly for the fifth to seventh planes PLN5 to PLN7 of the first to third ways WAY#1 to WAY#3. Consequently, as illustrate in FIG. 38C, the nonvolatile memory device 310 may reallocate the planes belonging to the zeroth way group WG#0 and the first plane group PG#1 from the second CA line CA#2 to the zeroth CA line CA#0.

Similarly, the LUN selection packet LUNSel may be received through the third CA line CA#3. The LUN selection packet LUNSel may indicate the fourth way WAY#4.

Then, the CA change header may be received through the third CA line CA#3.

Subsequently, the CA change body may be received through the third CA line CA#3. For example, the CA change body may include 8 bits where the first 4 bits '0001' may indicate the fourth plane PLN4, which is the target plane, and the last 4 bits '0010' may indicate the first CA line CA#1 to which the target plane will be reallocated.

Accordingly, the nonvolatile memory device 310 may reallocate the fourth plane PLN4 of the first way WAY#1 from the third CA line CA#3 to the first CA line CA#1.

These commands may be repeatedly received for the fifth to seventh planes PLN5 to PLN7 of the fifth to seventh ways WAY#5 to WAY#7. As a result, as illustrated in FIG. 38C, the nonvolatile memory device 310 may reassign the planes belonging to the first way group WG#1 and the first plane group PG#1 from the third CA line CA#3 to the first CA line CA#1.

As described above, the nonvolatile memory device according to the present disclosure may variably adjust the number of CA lines that receive the commands in response to the request from the memory controller.

In FIGS. 36, 37, and 38A to 38C, it has been described that the LUN selection packet is received. However, this is merely an example, and the present disclosure should not be limited thereto or thereby. According to implementations, the LUN selection packet may not be received, and address information for the way may be received separately.

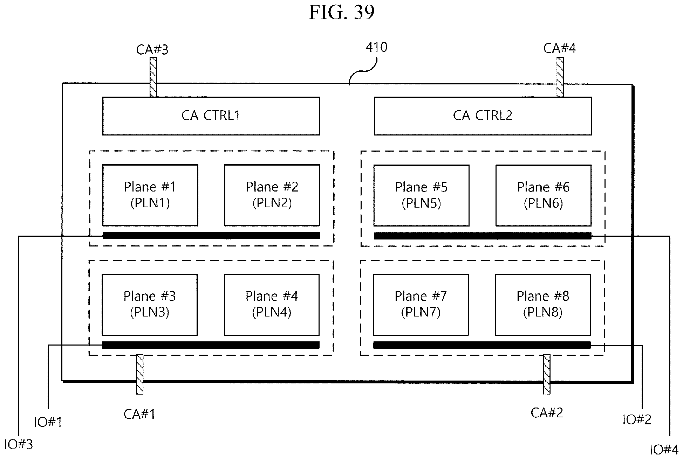

FIG. 39 is a block diagram illustrating a nonvolatile memory device 410 that supports reallocation of a CA pad set during rerouting according to some implementations of the present disclosure. The nonvolatile memory device 410 of FIG. 39 is similar to the nonvolatile memory devices 110, 210, 310 described above or the chip or die included in the nonvolatile memory device. Therefore, redundant descriptions will be omitted. For convenience of explanation, it is assumed that eight planes PLN1 to PLN8 are arranged on the nonvolatile memory device 410.

Referring to FIG. 39, the nonvolatile memory device 410 may include eight planes PLN1 to PLN8. A third CA line CA#3 and a third IO line IO#3 may be allocated to first and second planes PLN1 and PLN2 among the planes PLN1 to PLN8. A first CA line CA#1 and a first IO line IO#1 may be allocated to third and fourth planes PLN3 and PLN4. A fourth CA line CA#4 and a fourth IO line IO#4 may be allocated to fifth and sixth planes PLN5 and PLN6. A second CA line CA#2 and a second IO line IO#2 may be allocated to seventh and eighth planes PLN7 and PLN8.

In some implementations of the present disclosure, a first CA control circuit CA CTRL1 may correspond to the first and second planes PLN1 and PLN2. During rerouting, the first CA control circuit CA CTRL1 may change the CA line corresponding to the first and second planes PLN1 and PLN2. For example, when the first IO line IO#1 and the third IO line IO#3 are merged due to rerouting, the first CA control circuit CA CTRL1 may change the CA line allocated to the first and second planes PLN1 and PLN2 from the third CA line CA#3 to the first CA line CA#1.

In some implementations of the present disclosure, a second CA control circuit CA CTRL2 may correspond to the fifth and sixth planes PLN5 and PLN6. During rerouting, the second CA control circuit CA CTRL2 may change the CA line corresponding to the fifth and sixth planes PLN5 and PLN6. For example, when the second IO line IO#2 and the fourth IO line IO#4 are merged due to rerouting, the second CA control circuit CA CTRL2 may change the CA line allocated to the fifth and sixth planes PLN5 and PLN6 from the fourth CA line CA#4 to the second CA line CA#2.

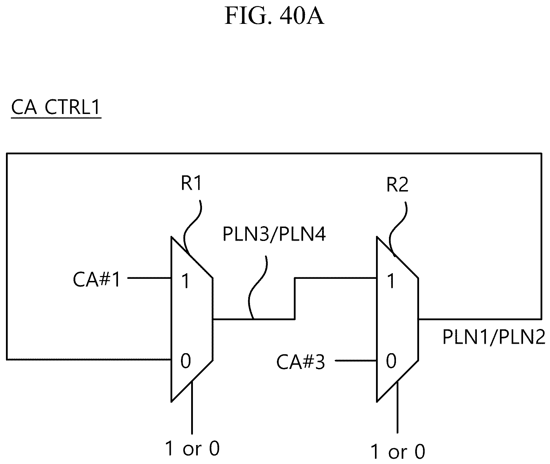

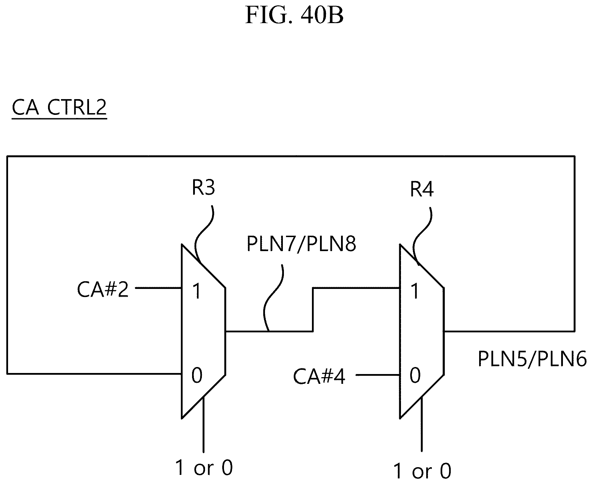

FIG. 40A is a view illustrating the first CA control circuit of FIG. 39, and FIG. 40B is a view illustrating the second CA control circuit of FIG. 39.

Referring to FIG. 40A, the first CA control circuit CA CTRL1 may include a plurality of multiplexers R1 and R2.

A first multiplexer R1 may receive a signal of the first CA line CA#1 and an output of a second multiplexer R2 as inputs. The first multiplexer R1 may select one of two inputs in response to a control signal. In this case, '1' or '0' may be provided as the control signal. For example, when the control signal is '1', the first CA line CA#1 may be selected. When the control signal is '0', the output of the second multiplexer R2 may be selected. An output of the first multiplexer R1 may be set as the CA line allocated to the third and fourth planes PLN3 and PLN4.

The second multiplexer R2 may receive a signal of the third CA line CA#3 and the output of the first multiplexer R1 as inputs. The second multiplexer R2 may select one of two inputs in response to a control signal. In this case, '1' or '0' may be provided as the control signal. For example, when the control signal is '0', the third CA line CA#3 may be selected. When the control signal is '1', the output of the first multiplexer R1 may be selected. The output of the second multiplexer R2 may be set as the CA line allocated to the first and second planes PLN1 and PLN2.

Similarly, referring to FIG. 40B, the second CA control circuit CA CTRL2 may include a plurality of multiplexers R3 and R4.

A third multiplexer R3 may receive a signal of the second CA line CA#2 and an output of a fourth multiplexer R4 as inputs. The third multiplexer R3 may select one of two inputs in response to a control signal. In this case, '1' or '0' may be provided as the control signal. For example, when the control signal is '1', the second CA line CA#2 may be selected. When the control signal is '0', the output of the fourth multiplexer R4 may be selected. An output of the third multiplexer R3 may be set as the CA line allocated to the seventh and eighth planes PLN7 and PLN8.

The fourth multiplexer R4 may receive a signal of the fourth CA line CA#4 and the output of the third multiplexer R3 as inputs. The fourth multiplexer R4 may select one of two inputs in response to a control signal. In this case, '1' or '0' may be provided as the control signal. For example, when the control signal is '0', the fourth CA line CA#4 may be selected. When the control signal is '1', the output of the third multiplexer R3 may be selected. The output of the fourth multiplexer R4 may be set as the CA line allocated to the fifth and sixth planes PLN5 and PLN6.

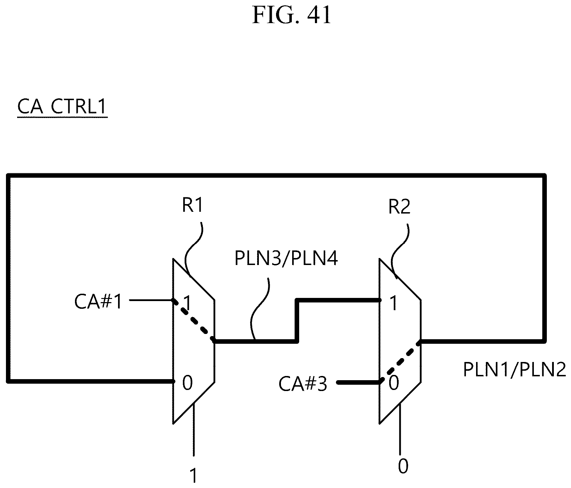

FIG. 41 is a view illustrating an operation of a CA control circuit when rerouting is not performed. For convenience of explanation, the first CA control circuit CA CTRL1 will be mainly described hereinafter.

Referring to FIGS. 39 and 41, when the rerouting is not performed, a control signal of '1' may be provided to the first multiplexer R1. Accordingly, the first CA line CA#1 may be allocated to the third and fourth planes PLN3 and PLN4. In addition, a control signal of '1' may be provided to the second multiplexer R2. Accordingly, the third CA line CA#3 may be allocated to the first and second planes PLN1 and PLN2.

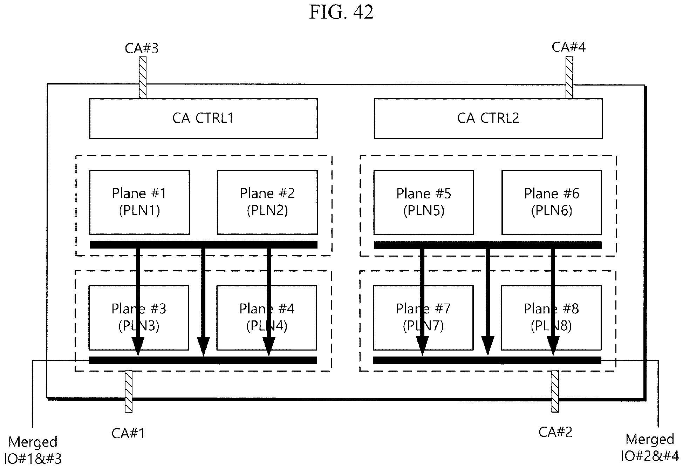

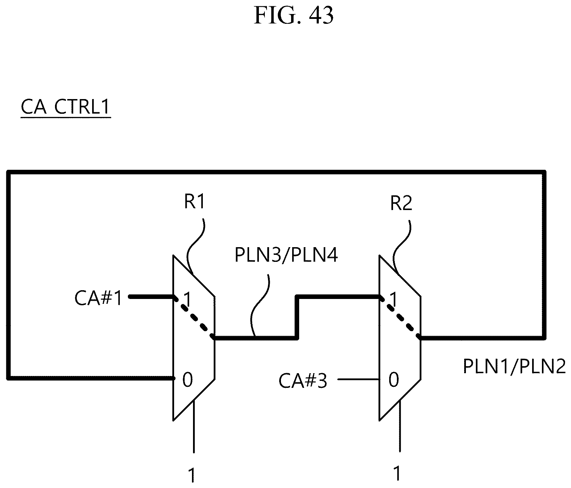

FIGS. 42 and 43 are views illustrating an operation of a CA control circuit during rerouting. For convenience of explanation, the first CA control circuit CA CTRL1 will be mainly described hereinafter.

Referring to FIGS. 42 and 43, the first IO line IO#1 and the third IO line IO#3 may be merged with each other during rerouting. In this case, the first CA control circuit CA CTRL1 may change the CA line corresponding to the first and second planes PLN1 and PLN2 from the third CA line CA#3 to the first CA line CA#1.

In detail, as illustrated in FIG. 43, during rerouting, a control signal of '1' may be provided to the first multiplexer R1. Accordingly, the first CA line CA#1 may be allocated to the third and fourth planes PLN3 and PLN4. Further, a control signal of '1' may be provided to the second multiplexer R2. Accordingly, the first CA line CA#1 may also be allocated to the first and second planes PLN1 and PLN2.

Similarly, the second IO line IO#2 and the fourth IO line IO#4 may be merged with each other during rerouting. In this case, the second CA control circuit CA CTRL2 may change the CA line corresponding to the fifth and sixth planes PLN5 and PLN6 from the fourth CA line CA#4 to the second CA line CA#2.

In a case where the allocated CA line is not changed during rerouting as described above, some planes may not be controlled due to the rerouting. For example, when the first IO line IO#1 and the third IO line IO#3 are merged with each other by rerouting, the first and second planes PLN1 and PLN2 may no longer be controlled by the third CA line CA#3. In contrast, the nonvolatile memory device 410 according to some implementations of the present disclosure may operate the planes without errors by changing the corresponding CA line during rerouting.

As used herein, the term "at least one of" can refer to and encompass any and all possible combinations of one or more of the associated listed terms. For example, the term "at least one of A, B, or C" means that (i) at least one of A, (ii) at least one of B, (iii) at least one of C, (iv) at least one of A and at least one of B, (v) at least one of B and at least one of C, (vi) at least one of A and at least one of C, or (vi) at least one of A, at least one of B and at least one of C are possible, where A, B and C may be singular or plural.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations, one or more features from a combination can in some cases be excised from the combination, and the combination may be directed to a sub-combination or variation of a sub-combination.

While the present disclosure has been described with reference to implementations thereof, it will be apparent to those of ordinary skill in the art that various changes and modifications may be made thereto without departing from the scope of the present disclosure as set forth in the following claims.

## Claims

1. A nonvolatile memory device (110, 210) comprising:
a memory cell array (111, 211) comprising a plurality of planes;
a page buffer circuit (115, 215) connected to the memory cell array (111, 211) through a plurality of bit lines;
an input/output circuit (116, 216) connected to the page buffer circuit (115, 215) through a plurality of data lines;
a control logic circuit (114, 214) configured to control an operation for the plurality of planes based on a command;
a first command-address pad set (CA_S0) electrically connected to the control logic circuit (114, 214), wherein the first command-address pad set (CA_S0) is configured to receive a first command (CMD1); and
a second command-address pad set (CA_S1) electrically connected to the control logic circuit (114, 214), wherein the second command-address pad set (CA_S1) is configured to receive a second command (CMD2), and
wherein a reception duration of the first command (CMD1) overlaps with a reception duration of the second command (CMD2).

2. The nonvolatile memory device (110, 210) of claim 1, wherein the first command (CMD1) comprises:
a first read command requesting a read operation for a first plane among the plurality of planes;
a first status read, SR, command requesting a status of completion of the read operation corresponding to the first plane; and
a first data out command requesting an output of data read from the first plane, and wherein the second command (CMD2) comprises:
a second read command requesting a read operation for a second plane among the plurality of planes;
a second SR command requesting a status of completion of the read operation corresponding to the second plane; and
a second data out command requesting an output of data read from the second plane.

3. The nonvolatile memory device (210) of claim 1 or 2, comprising a command-address control circuit (217) electrically connected to the first command-address pad set (CA_S0) and the second command-address pad set (CA_S1), wherein the command-address control circuit (217) is configured to select at least one plane of the plurality of planes and allocate the first command-address pad set (CA_S0) and the second command-address pad set (CA_S1) to the at least one plane.

4. The nonvolatile memory device (210) of claim 3, wherein the command-address control circuit (217) is configured to determine the at least one plane of the plurality of planes based on a size of data.

5. The nonvolatile memory device (210) of claim 4, wherein the command-address control circuit (217) is configured to allocate, based on the size of the data being larger than a reference size, at least two planes among the plurality of planes to the first command-address pad set (CA_S0).

6. The nonvolatile memory device (210) of claim 5, wherein the command-address control circuit (217) is configured to cut-off an electrical connection of a command-address line connected to the second command-address pad set (CA_S1).

7. The nonvolatile memory device (210) of claim 4, wherein the command-address control circuit (217) is configured to allocate, based on the size of the data being smaller than a reference size, the first command-address pad set (CA_S0) and the second command-address pad set (CA_S1) to different planes among the plurality of planes.

8. The nonvolatile memory device (210) of claim 7, comprising:
a third command-address pad set (CA_S2) electrically connected to the control logic circuit (217), wherein the third command-address pad set (CA_S2) is configured to receive a third command (CMD3); and
a fourth command-address pad set (CA_S3) electrically connected to the control logic circuit (217), wherein the fourth command-address pad set (CA_S3) is configured to receive a fourth command (CMD4),
wherein the command-address control circuit (217) is configured to cut-off an electrical connection of a command-address line connected to the third command-address pad set (CA_S2) and configured to cut-off an electrical connection of a command-address line connected to the fourth command-address pad set (CA_S3).

9. The nonvolatile memory device (210) of claim 7, comprising:
a third command-address pad set (CA_S2) electrically connected to the control logic circuit (217), wherein the third command-address pad set (CA_S2) is configured to receive a third command (CMD3); and
a fourth command-address pad set (CA_S3) electrically connected to the control logic circuit (217), wherein the fourth command-address pad set (CA_S3) is configured to receive a fourth command (CMD4),
wherein the first command-address pad set (CA_S0), the second command-address pad set (CA_S1), the third command-address pad set (CA_S2), and the fourth command-address pad set (CA_S3) are allocated to different respective planes from among the plurality of planes.

10. The nonvolatile memory device (210) of claim 3, wherein the command-address control circuit (217) is configured to determine the at least one plane among the plurality of planes based on a command-address change request from a memory controller (22).

11. The nonvolatile memory device (210) of claim 10, wherein the command-address change request comprises a header and a body, and wherein the body comprises address information for a plane to which the first command-address pad set (CA_S0) is allocated.

12. The nonvolatile memory device (210) of claim 10, wherein the command-address change request comprises a logical unit number, LUN, selection signal, and wherein the LUN selection signal comprises address information for a way allocated to the first command-address pad set (CA_S0).

13. The nonvolatile memory device (210) of any of claims 3 to 12, wherein the command-address control circuit (217) and the memory cell array (211) are arranged on a same die.

14. The nonvolatile memory device (210) of any of claims 3 to 12, wherein the command-address control circuit (217) and the memory cell array (211) are arranged on different dies.

15. The nonvolatile memory device (110, 210) of any preceding claim, comprising:
a first data pad set (DQ_S1) electrically connected to the input/output circuit (116, 216), wherein the first data pad set (DQ_S1) is configured to output a first data (DATA1) corresponding to the first command (CMD1); and
a second data pad set (DQ_S1) electrically connected to the input/output circuit (116, 216), wherein the second data pad set (DQ_S2) is configured to output a second data (DATA2) corresponding to the second command (CMD2).
